(19) Europäisches Patentamt

European Patent Office

Office européen des brevets

(11) EP 1 124 268 A2

(12) EUROPEAN PATENT APPLICATION

(43) Date of publication:
16.08.2001 Bulletin 2001/33

(51) Int Cl.$^7$: H01L 41/20

(21) Application number: 01102795.0

(22) Date of filing: 09.02.2001

(84) Designated Contracting States:
AT BE CH CY DE DK ES FI FR GB GR IE IT LI LU MC NL PT SE TR
Designated Extension States:
AL LT LV MK RO SI

(30) Priority: 10.02.2000 JP 2000033967
14.04.2000 JP 2000113514

(71) Applicant: KABUSHIKI KAISHA TOSHIBA
Kawasaki-shi, Kanagawa-ken (JP)

(72) Inventors:
• Arai, Tomohisa,
Minato-ku, Tokyo (JP)
• Yamamiya, Hideki,
Minato-ku, Tokyo (JP)
• Okamura, Masami,
Minato-ku, Tokyo (JP)
• Kobayashi, Tadahiko,
Minato-ku, Tokyo (JP)

(74) Representative: HOFFMANN - EITLE
Patent- und Rechtsanwälte
Arabellastrasse 4
81925 München (DE)

(54) Giant magnetostrictive material and manufacturing method thereof, and magnetostrictive actuator and magnetostrictive sensor therewith

(57) Giant magnetostrictive material, with an alloy including a rare earth element and a transition metal element, is obtained by dissolving nitrogen interstitially in the alloy. Nitrogen is introduced in the alloy in the range from 0.01 to 2.5 % by mass. Nitrogen introducing treatment is carried out at a temperature of 600°C or less. A content of nitrogen compound present in magnetostrictive alloy, by a ratio of a content of nitrogen in the nitrogen compound to a total nitrogen content in the alloy, is reduced to be 0.05 or less by mass ratio. Almost all of the added nitrogen is interstitially dissolved between crystal lattice. In giant magnetostrictive material using melt quench flakes, the flakes are stacked in a thickness direction that is a direction of growth of columnar grain essentially constituting the flake material to integrate in this state.

FIG. 1

**Description**

The present invention relates to giant magnetostrictive material used for a magneto-mechanical transducer and a manufacturing method thereof, and a magnetostrictive actuator and sensor therewith.

As devices in which transformation at the application of an external magnetic field on magnetic material, that is, so-called magnetostriction is utilized, such as a displacement actuator, a magnetostrictive sensor, a magnetostrictive filter, an ultrasonic oscillator and an ultrasound delay line are known. In the applications, as the magnetostrictive materials, Ni base alloy, Fe-Co alloy, ferrite and so on have been used.

Recently, accompanying progress in instrumentation technology and development in precision machinery, a displacement actuator indispensable for micro-displacement control of micron order is in great demand for development. As one of mechanism of such displacement actuator, a magneto-mechanical transducer using magnetostrictive alloy is regarded as the most potential candidate. However, existing magnetostrictive alloys are insufficient in the absolute value of displacement. Furthermore, as parts and material for precision driving of micron order, in addition to being poor in the absolute actuator displacement, from a viewpoint of precision control, these are not satisfactory.

To such demands, rare earth-transition metal base magnetostrictive alloy drew attention, some of these being put into practical use (cf. Japanese Patent Publication (KOKOKU) No. Sho 61-33892, USP 478,258 Specification and so on). However, the existing rare earth-transition metal base magnetostrictive alloy is not sufficient in the temperature characteristics such as Curie temperature or the like. For instance, in rare earth-iron alloy, magnetostriction deteriorates in a low temperature region. Furthermore, rare earth-cobalt alloy is difficult to use under a high temperature environment.

For an improvement of temperature characteristics of the rare earth-transition metal base magnetostrictive alloy, for instance, in Japanese Patent Publication (KOKAI) No. Hei 5-51704, giant magnetostrictive alloy expressed by $R_m T_{100-m-n} M_n$ is disclosed. Here, R denotes at least one kind selected from rare earth elements including Y, T at least one kind selected from iron and cobalt, and M at least one kind selected from B, C and N, wherein $20 \leqq m \leqq 60$ atomic % and $0 < n \leqq 30$ atomic %. In the giant magnetostrictive alloy, at least one kind of M element selected from B, C and N intrudes into a lattice of primary phase, and being called an interstitial element. By making use of the property of the interstitial element, Curie temperature is improved.

However, when adding nitrogen (N) in the rare earth-transition metal alloy, alloy melt and nitrogen or a gas containing nitrogen are made to come into contact to introduce nitrogen in the alloy. Accordingly, most nitrogen introduced into the alloy reacts with a rare earth element or iron to form nitride. In such mode, though Curie temperature may be heightened, generated nitride deteriorates the magnetostriction, furthermore mechanical properties.

That is, when adding nitrogen to the rare earth-transition metal alloy in a molten state or at a high temperature where sintering can be implemented, in the form of the interstitial alloy effective in raising Curie temperature, nitrogen can be dissolved with difficulty. Furthermore, it is extremely difficult to control nitrogen concentration to the optimum value. For instance, with nitrogen diluted by an inert gas, and while sufficiently agitating the molten metal, nitrogen and the molten metal are made to come into contact to introduce nitrogen in the alloy. However, an amount of nitrogen effectively operating is extremely slight, similarly with the above most of the added nitrogen forming nitride to cause deterioration of the magnetostriction or mechanical characteristics. Even in the case of sintering rare earth-transition metal base alloy in an atmosphere of nitrogen, similarly nitride is formed. There are problems from a viewpoint of practical use.

Recently, the magnetostrictive alloy is under study to apply in various usage, for instance, in the case of automobile use, the use under an environment exceeding 100°C is assumed. However, the existing magnetostrictive alloy deteriorates in magnetostriction under a high temperature environment, resulting in being hindered from putting into practical use. Thus, the existing giant magnetostrictive material is restricted in usage from a viewpoint of temperature characteristics. It is strongly demanded to improve Curie temperature to improve the above point, accordingly.

Furthermore, the existing rare earth-transition metal base magnetostrictive alloy, due to the process of manufacture, has the following disadvantages. The rare earth-transition metal base magnetostrictive alloy, showing large magnetostriction in a particular crystallographic direction, needs to align a crystallographic direction when forming in bulk. For such points, at the beginning, a single crystal is used. However, due to an expensive process such as the Bridgman method, its usage is restricted to military use.

To overcome the problems, for the magnetostrictive alloy, though a little poor in characteristics as the magnetostrictive material, to be broadly used, the following two cost reduction processes are put into practical use. The first process is unidirectional solidification process. That is, molten magnetostrictive alloy is cast into a mold having a temperature gradient to produce a polycrystalline ingot of which crystallographic direction is aligned. From the polycrystalline ingot, magnetostrictive material of necessary shape is cut out to use.

The second process is one to process into near net shape by means of powder metallurgy. That is, two kinds or more of raw material powder of different compositions are prepared and mixed to get a prescribed composition ratio. The mixture, while magnetically orienting so that an easy direction of magnetization of at least one raw material is directed to a direction therefrom taking out magnetostriction, is molded, followed by sintering the molded body. According to the process, sintered alloy having a target composition and orientation can be obtained.

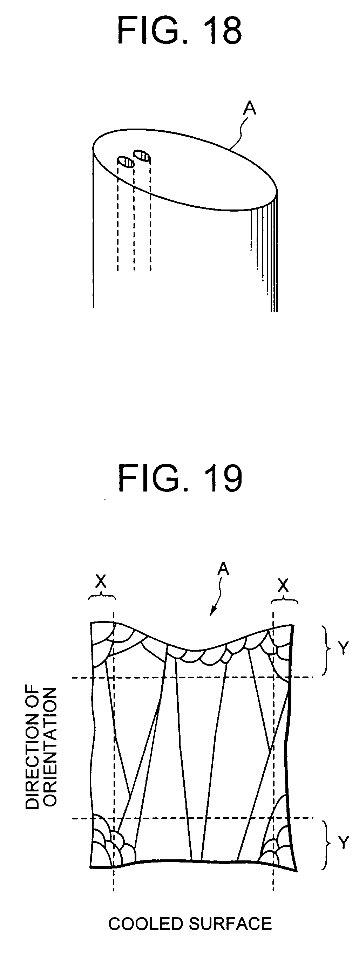

However, the aforementioned unidirectional solidification process and powder metallurgy process have disadvantages as shown in the following. The shape or magnitude of an ingot obtainable by the use of the unidirectional solidification process is restricted. Accordingly, when a product shape is small, from a large cylindrical ingot as shown in Fig. 18 for instance, material has to be cut out into a target shape. On the other hand, when a target shape is larger than the ingot A, ones that are once cut out into prescribed shapes have to be joined. Anyway, when cutting out of the ingot A in a prescribed shape, as shown in Fig. 19, expensive material is wasted as cutting margin X.

Furthermore, even in the case of unidirectional solidification, at upper and lower ends of the direction of orientation of the ingot A, equi-axed grains are formed. A portion B including the equi-axed grains, since deteriorating magnetostriction, is cut to discard. Thus, the unidirectional solidification process has a problem that utilization efficiency of material is low. In addition to the above, there is another problem that the rare earth-transition metal alloy, being brittle, can be processed with a lot of trouble.

In the powder metallurgy, such fine powder as is close in characteristics to single crystal, that is, powder obtained by finely milling the ingot to a diameter of 10 $\mu$m or less is put in a mold. It is sintered under a magnetic field to be a near net shape. Accordingly, the material waste can be suppressed to the minimum level. However, the powder obtained by finely milling the ingot, being large in specific surface area, can be easily oxidized. As a result, in the processes of milling, forming and sintering, oxygen concentration increases remarkably. An increase of the oxygen concentration causes deterioration of characteristics of magnetostrictive material, resulting in lowering of yield of the magnetostrictive material.

On the other hand, as an improved powder metallurgy process, for instance in Japanese Patent Publication (KOKAI) Nos. HEI 1-246342 and HEI 4-52246, a process for manufacturing magnetostrictive material is disclosed. In the process, molten rare earth-transition metal alloy is quenched to prepare raw material powder, the raw material powder being integrated by means of hot pressing (HP) or hot isostatic pressing (HIP) to prepare the magnetostrictive material.

However, in Japanese Patent Publication (KOKAI) No. HEI 1-246342, alloy thin ribbon or alloy flake, after milling, undergoes HP treatment or HIP treatment. As a result, similarly with the existing powder metallurgy process, the magnetostrictive material deteriorates in characteristics. Furthermore, crystallographic direction of anisotropic magnetostrictive alloy cannot be sufficiently aligned, resulting in only a cubic sintered body. This causes deterioration of magnetostriction. The quenching process of the molten alloy in Japanese Patent Publication (KOKAI) No. HEI 1-246342 is implemented with an intention to make grain diameter finer.

Furthermore, in Japanese Patent Publication (KOKAI) No. HEI 4-52246, it only discloses to prepare raw material powder by quenching molten rare earth-transition metal alloy and does not intend to control shape or crystal structure of the flake like raw material obtained by quenching. Accordingly, the crystallographic direction of anisotropic magnetostrictive alloy cannot be sufficiently aligned, resultantly the magnetostriction cannot be fully enhanced. Furthermore, here the material densified by the process of HP or HIP process undergoes furthermore hot plastic deformation process to orient grains in a particular direction. When implementing thus the process in multi-stages to improve magnetostriction, an increase of manufacturing cost of the magnetostrictive material is caused.

Summary of the Invention

Accordingly, an object of the present invention is to provide giant magnetostrictive material that, by effectively introducing nitrogen interstitially to rare earth-transition metal base magnetostrictive alloy, enables to enhance Curie temperature with reproducibility and to obtain excellent magnetostriction and mechanical characteristics, and a manufacturing method thereof. Another object of the present invention is to provide giant magnetostrictive material that in addition to an enhancement of material use efficiency and yield, enables to obtain excellent magnetostriction and mechanical characteristics. Still another object of the present invention is to provide a magnetostrictive actuator and a magnetostrictive sensor in which by the use of such giant magnetostrictive material, in addition to enhancing characteristics and reliability under various environments, manufacturing cost is reduced.

The present inventors, first, have variously studied a method of adding nitrogen to rare earth-transition metal base magnetostrictive alloy and an optimum concentration of nitrogen. As a result of the study, it is found that by introducing nitrogen under such a low temperature environment as 600°C or less, while suppressing crystal structure effective for magnetostriction from breaking down and nitride from forming, nitrogen can be effectively introduced interstitially in magnetostrictive alloy. Thereby, while suppressing characteristics of rare earth-transition metal base magnetostrictive alloy from deteriorating, the Curie temperature can be effectively enhanced.

A first giant magnetostrictive material of the present invention is attained based on such a finding. The first giant magnetostrictive material comprises a mother alloy of which primary components are rare earth and transition elements, and nitrogen contained in the mother alloy. Here, the nitrogen is interstitially dissolved in the mother alloy, a content of nitrogen compound in the mother alloy, as a ratio of a content of nitrogen contained in the nitrogen compound to a total content of nitrogen in the mother alloy, being 0.05 or less by mass ratio.

The first giant magnetostrictive material contains nitrogen in the range from 0.01 to 2.5 % by mass with respect to a total mass of the alloy. The content of nitrogen here is a total content of nitrogen in the alloy. At that time, a dispersion of the content of nitrogen dissolved interstitially in the mother alloy is preferable to be within $\pm 30$ % or less to an average value thereof.

In the first giant magnetostrictive material of the present invention, the mode of the magnetostrictive alloy is not particularly restricted, but various kinds of alloy materials for instance such as unidirectionally solidified material, single crystal, quenched molten metal, sintered body due to powder metallurgy, or isotropic cast material can be used. Furthermore, an alloy thin film due to thin film deposition may be used.

A method of manufacturing the first giant magnetostrictive material of the present invention comprises the steps of heat treating a mother alloy of which primary components are rare earth and transition elements in a vacuum or inert gas atmosphere, and of adding nitrogen by dissolving interstitially into a crystal lattice of the previously heat treated mother alloy in a temperature region of 600°C or less.

In the method of manufacturing the first giant magnetostrictive material, further in the step of adding nitrogen, the nitrogen is controlled to be contained in the mother alloy in the range from 0.01 to 2.5 % by mass, and a content of nitrogen compound in the mother alloy, by a mass ratio of a content of nitrogen contained in the nitrogen compound to a total content of nitrogen in the mother alloy, to be 0.05 or less.

In the method of manufacturing the first magnetostrictive material, the step of adding nitrogen is preferably implemented for instance by heat treating the mother alloy for instance in an atmosphere containing nitrogen at a temperature in the range from 200 to 600°C, or by mechanically alloying the mother alloy in an atmosphere containing nitrogen. Furthermore, the mother alloy after the step of adding nitrogen is preferable to be heat treated, in an inert atmosphere at a temperature in the range from 200 to 600°C, to homogenize nitrogen distribution in the mother alloy. At that time, the steps of adding nitrogen and of heat treating to homogenize may be alternately repeated.

In a number of magnetostrictive alloys, the nitrogen addition causes a rise of Curie temperature. However, as to the magnetostriction, there are increasing cases and decreasing cases. In particular, one that shows a decrease, from compatibility point of view between an environment to use (temperature or the like) and necessary characteristics of the magnetostrictive material, the content of nitrogen is necessary to be optimized. From the above, the nitrogen is necessary to be contained by an amount that is compatible with the temperature characteristics and magnetostriction. The nitrogen is preferable to be contained in the range from 0.01 to 2.5 % by mass with respect to a total mass of the alloy. However, even if the nitrogen content is the optimum value, high generation of nitrogen compounds such as nitride causes problems in the mechanical reliability as well as magnetostriction.

In the present invention, by appropriately controlling the temperature condition or the like during the nitrogen addition, the nitrogen is interstitially dissolved as a nitrogen atom in the crystal lattice of the primary phase of the magnetostrictive alloy. Simultaneously, the nitrogen compound is suppressed from generating. More specifically, the content of nitrogen compound present in the magnetostrictive alloy is reduced to be 0.05 or less by a ratio (mass ratio) of a content of nitrogen contained in the nitrogen compound to the total content of nitrogen. Thereby, it becomes possible to provide giant magnetostrictive material that is high in Curie temperature and excellent in magnetostriction, in addition, excellent in mechanical reliability.

A second giant magnetostrictive material of the present invention comprises melt quench flakes consisting of a alloy including a rare earth element and a transition metal element as primary components, and containing columnar structure grains extending in a thickness direction as a main crystal structure. The melt quench flakes is stacked integrated in the thickness direction.

A method of manufacturing the second giant magnetostrictive material of the present invention comprises the steps of preparing melt quench flakes, and stacking the melt quench flakes to integrate. In the step of preparing the melt quench flakes, alloy melt including a rare earth element and a transition metal element is quenched to prepare the melt quench flakes containing of columnar structure grains extending in a thickness direction as a main crystal structure. In the step of stacking the melt quench flakes to integrate, the melt quench flakes is stacked in a thickness direction to integrate. In the method of manufacturing the second giant magnetostrictive material, in the step of stacking to integrate, the melt quench flakes is stacked so that a crystallographic direction in a thickness direction of the columnar grain is oriented.

In the method of manufacturing the second giant magnetostrictive material, in the step of stacking to integrate, a process for integrating the stacked body of the melt quench flakes by the use of a hot press or spark plasma sintering, or a process for integrating the stacked body of the melt quench flakes by the use of resinous binder may be applied. Furthermore, the method of manufacturing the second giant magnetostrictive material comprises a step of heat treatment to grow and/or homogenize the melt quench flakes.

In the second giant magnetostrictive material of the present invention, melt quench flakes containing columnar structure grains extending in a thickness direction as a main crystal structure is used. That is, in the melt quench flakes, by approximating a cooling speed during the quenching the melt of the magnetostrictive alloy, a crystal structure mainly constituting of columnar structure grains extending in a thickness direction can be obtained. In the giant magnetostrictive material based on rare earth-transition metal, a growth direction in a thickness direction of the columnar structure grains coincides with the crystallographic direction larger in magnetostriction. Accordingly, in the melt quench flakes mainly constituting of the columnar structure grains extending in a thickness direction, by stacking in a thickness direction by making use of shape effect thereof to integrate, the giant magnetostrictive material excellent in the magnetostriction can be obtained with reproducibility.

Furthermore, in the giant magnetostrictive material consisting of a stacked and integrated body of the melt quench flakes, based on a state of orientation of the columnar structure and a state of stacking of the melt quench flakes, the crystallographic orientation of the entire material can be aligned. In an existing unidirectional solidification material, a cutting margin or waste portion is inevitably caused at four sides of the material. On the contrary, in the present invention, such useless portion is hardly generated to result in a reduction of manufacturing cost of the giant magnetostrictive material. In addition to this, the melt quench flakes, being small in a specific surface area in comparison with that of fine powder used in the existing powder metallurgy as raw material powder, can suppress deterioration of magnetostriction due to oxidation from occurring.

In the second giant magnetostrictive material, the melt quench flakes contain the columnar structure grains extending in a thickness direction, more specifically is preferable to contain the columnar structure grains of 70 % or more by volume ratio. Furthermore, the crystallographic direction in the thickness direction of the columnar structure grains mainly constituting the melt quench flakes is preferable to be approximate {1,1,0} or {1,1,1}. As to the crystallographic direction of the columnar grain here, when the columnar structure grains grow in a direction of {1,1,0} or {1,1,1}, such a direction of crystal growth needs only to be within $\pm45$ degrees with respect to a thickness direction of the flake material. Furthermore, it is preferable to contain 75 % or more by volume of the columnar structure grains satisfying such condition.

Fig. 1 is a diagram showing schematically an essential configuration of one embodiment of the second giant magnetostrictive material of the present invention,

Figs. 2A and 2B are diagrams for explaining a method for measuring an angle between a thickness direction and a crystallographic direction of melt quench flake material,

Fig. 3 is a diagram for explaining dispersion in a stacked state when the melt quench flake material is stacked,

Fig. 4 is a perspective view showing an example of shape of melt quench flake material using in the present invention,

Figs. 5A, 5B and 5C are diagrams for explaining the relationship between quenching speed of the melt and crystalline state of the melt quench flake material,

Fig. 6 is a diagram showing the relationship between temperature and magnetization of the first giant magnetostrictive material in comparison with that of alloy material therein no nitrogen is added,

Fig. 7 is a diagram showing the relationship between content of nitrogen and magnetostriction of the magnetostrictive material with environment temperature as a parameter,

Fig. 8 is a diagram showing the relationship between oxygen concentration and deflective strength of magnetostrictive material,

Fig. 9 is a diagram showing the relationship between fluorine concentration and deflective strength of magnetostrictive material,

Fig. 10 is a sectional view showing a schematic configuration of an embodiment where a magnetostrictive actuator of the present invention is applied in a hydraulic valve,

Fig. 11 is a perspective view showing a schematic configuration of an embodiment where a magnetostrictive sensor of the present invention is applied in a torque sensor,

Fig. 12 is a front view showing a schematic configuration of a modification example of the torque sensor shown in Fig. 11,

Fig. 13 is a perspective view showing a schematic configuration of an embodiment where a magnetostrictive sensor of the present invention is applied in a knocking sensor,

Fig. 14 is a diagram showing an example of configuration of a spark plasma sintering device used in an embodiment of the present invention,

Fig. 15 is a diagram showing the relationship between peak intensity ratio and value of magnetostriction of melt quench flake material,

Fig. 16 is a diagram showing the relationship between volume ratio of columnar structure grains growing in a thickness direction of the melt quench flake material and magnetostriction (relative value),

Fig. 17 is a diagram showing the relationship between average thickness of the melt quench flake material and volume ratio of columnar structure grains growing in a thickness direction with dispersion of the average thickness as parameter,

Fig. 18 is a schematic perspective view showing cutting out of an existing unidirectional solidification material,

Fig. 19 is a schematic sectional view of an existing unidirectional solidification material.

In the following, modes for implementing the present invention will be explained.

In the first giant magnetostrictive material of the present invention, a mother alloy (magnetostrictive alloy) consisting essentially of a rare earth element and a transition metal element contains nitrogen in the range from for instance 0.01 to 2.5 % by mass. Here, as the rare earth-transition metal alloys showing giant magnetostriction, alloys containing, as the transition metal element, one kind or two kinds or more of transition metals selected from Fe, Co and Ni can be cited.

As a specific example of such rare earth-transition metal alloy, an alloy having a composition substantially expressed by

$$\text{General formula : } R (T_X M_{1-X})_Z \tag{1}$$

can be cited. In the formula, R denotes at least one kind of element selected from rare earth elements including Y, T denoting at least one kind of element selected from Fe, Co and Ni, M denoting at least one kind of element selected from transition metal elements excluding the aforementioned T elements. X and Z are numbers satisfying $0.5 \leqq X \leqq 1$, $1.4 \leqq Z \leqq 2.5$.

A value of Z showing a ratio of rare earth element and transition metal element is preferable to be in the range from 1.4 to 2.5. When Z is less than 1.4, a ratio of Laves phase that is a primary phase decreases. On the other hand, when the value of Z exceeds 2.5, an irregular phase is greatly generated. Accordingly, the magnetostriction deteriorates and mechanical strength decreases. The value of Z is further preferable to be in the range from 1.7 to 2.3.

In the transition metal element, at least one kind of T element selected from Fe, Co and Ni is a primary constituent element. However, as demands arise, part of the T element may be substituted by the M element selected from the transition metal elements other than the above. As the M element, at least one kind of element selected from for instance Mn, Cr, Mg, Al, Ti, V, Cu, Zn, Ga, Ge, Zr, Nb, Mo, In, Sn, Hf, Ta, W, Re, Ir, B, C, P and Si can be used. By substituting for part of the T element by such M element, magnetostriction, magnetic anisotropy of rare earth atoms, material strength and corrosion resistance can be improved.

An amount of substitution by the M element is preferable to be 50 % or less of a total amount of the T element. When the amount of substitution of the T element by the M element exceeds 50 %, the magnetostriction of the rare earth-transition metal alloy may deteriorate or Curie temperature may tend to lower. For the M element as the substitution element, Mn, Cr, Zn, Mo, Al, Ga and Zr are preferably used. A combination substitution due to Mn-Zn, Mn-Zr, Mn-Al or the like may be implemented.

As the rare earth elements, Y, La, Ce, Pr, Nd, Pm, Sm, Eu, Gd, Tb, Dy, Ho, Er, Tm, Yb and Lu can be used. In particular, Tb, Dy, Ho, Er, Tm, Pm, Pr, Nd, Sm or the like can be preferably used. Furthermore, as a combination of two or more kinds of rare earth elements, Tb-Dy, Tb-Ho, Tb-Dy-Ho, Tb-Pr, Tb-Dy-Pr, Tb-Pr-Ho, Tb-Dy-Nd, Sm-Yb, Sm-Er, Sm-Pm, Sm-Er-Pm, Sm-Ho and Sm-Dy can be preferably used.

As examples of specific composition of rare earth-transition metal alloy, $YFe_2$, $SmFe_2$, $GdFe_2$, $TbFe_2$, $Tb(NiFe)_2$, $Tb(CoFe)_2$, $DyFe_2$, $HoFe_2$, $ErFe_2$, $TmFe_2$, $Tb_a Dy_{1-a} Fe_2$ $(0 \leqq a \leqq 1.0)$, $Tb_a Dy_{1-a-b} Ho_b Fe_2$ $(0 \leqq a \leqq 1.0, 0 \leqq b \leqq 1.0)$, $Sm_a Dy_{1-a} Fe_2$ $(0 \leqq a \leqq 1.0)$, $Sm_a Ho_{1-a} Fe_2$ $(0 \leqq a \leqq 1.0)$ or the like can be cited.

In the first giant magnetostrictive material of the present invention, between the crystal lattice of the primary phase of the rare earth-transition metal alloy as mentioned in the above, an appropriate amount of nitrogen is interstitially dissolved as nitrogen atom. In a number of magnetostrictive alloys, an increase of the Curie temperature is found due to introduction of nitrogen. However, as to magnetostriction, there are both of increasing cases and decreasing cases. In particular, for ones of which magnetostriction decreases, from a compromise between the use environment (such as temperature and so on) of the giant magnetostrictive material and necessary characteristics thereof, the nitrogen content has to be optimized.

However, even if the nitrogen content is optimized, when much of the added nitrogen forms the nitrogen compounds such as rare earth nitride or iron nitride, in spite of an increase of the Curie temperature, there occur problems in not only magnetostriction but also in mechanical reliability. That is, when the temperature is too high during the nitrogen addition, the nitrogen compound tends to form easily to cause a change in the crystal structure, resulting in deterioration of magnetostriction. Furthermore, an increase of the generated nitrogen compound or excessive nitridation causes an increase of internal strain, on the basis thereof the mechanical characteristics being adversely affected. In the worst case, self-breakdown may occur.

From the above, in the present giant magnetostrictive material, first an amount of the nitrogen compound present in the magnetostrictive alloy, by a ratio (mass ratio) of a content of nitrogen contained in the nitrogen compound to a total content of nitrogen in the alloy, is reduced to be 0.05 or less. That is, the content of the nitrogen contained in the nitrogen compound is made 5 % or less by mass to the total content of nitrogen in the alloy. In other words, nitrogen of 95 % or more by mass of the total content of nitrogen added to the magnetostrictive alloy is interstitially dissolved in the primary phase of the magnetostrictive alloy as nitrogen atom.

As mentioned in the above, by controlling the formation of the nitrogen compound and dissolving interstitially most of the added nitrogen in the primary phase, while suppressing the crystal structure useful for magnetostriction from breaking down and the mechanical characteristics from deteriorating accompanying the formation of the nitrogen compound, an increase effect of the Curie temperature due to nitrogen addition can be effectively obtained.

That is, when the content of nitrogen contained in the nitrogen compound exceeds 0.05 by a mass ratio with respect to the total content of nitrogen in the alloy, based on the amount of formation of the nitrogen compound, deterioration of magnetostriction or mechanical characteristics is caused. The amount of the generated nitrogen compound is preferably controlled to be 0.03 or less by the mass ratio with respect to the total amount of nitrogen contained therein. As to the interstitial introduction of the nitrogen, as explained below, it is effective to lower the temperature when adding nitrogen, specifically the nitrogen addition under a low temperature environment such as 600°C or less.

The content of nitrogen (total nitrogen content) of the giant magnetostrictive material is preferable to be in the range from 0.01 to 2.5 % by mass with respect to a total mass of alloy. The nitrogen content is furthermore preferable to be in the range from 0.02 to 2.3 % by mass. When the nitrogen content of the giant magnetostrictive material is less than 0.01 % by mass, by the interstitial introduction of the nitrogen, a sufficient enhancement effect of the Curie temperature of the rare earth-transition metal alloy cannot be obtained. On the other hand, the nitrogen content, when exceeding 2.5 % by mass, may exceed an interstitial solubility limit. As a result, as mentioned in the above, an increase of the amount of generated nitride or internal strain is caused.

The total content of nitrogen in the giant magnetostrictive material of the present invention is a value measured based on analysis by LECO analyzer (inert gas fusion-thermalconductivity method). A content of nitrogen dissolved interstitially in the rare earth-transition metal alloy (mother alloy) denotes a value obtained by averaging nitrogen concentrations (excluding the nitrogen content present as the nitride) due to line profile analysis by means of EPMA (Electron Probe Microanalyzer). The nitrogen content contained in the nitrogen compound in the alloy is a value obtained by subtracting the interstitial nitrogen content due to EPMA (average value of the concentrations of nitrogen interstitially dissolved in the mother alloy) from the total nitrogen content due to analysis by LECO analyzer.

More specifically, by analyzing the nitrogen content of the giant magnetostrictive material due to LECO method, the total nitrogen content in the giant magnetostrictive material can be obtained. Then, the nitrogen content in the giant magnetostrictive material is measured by the line profile analysis due to EPMA. In measurements due to the EPMA line profile analysis, a total area thereof is the total nitrogen content in the giant magnetostrictive material. This corresponds to the measurement due to the analysis by LECO analyzer. In the line profile analysis due to the EPMA, when the nitrogen compound is present, a peak appears as a singular point. Accordingly, by subtracting an area of the singular point from the total area, a concentration of nitrogen dissolved as simple nitrogen in the mother alloy can the nitrogen content dissolved interstitially in the rare earth-transition metal alloy.

In the first giant magnetostrictive material of the present invention, the dispersion of the content of the interstitially dissolved nitrogen (the nitrogen concentration excluding the nitrogen content present as the nitride) is preferable to be within ± 30 % with respect to the value averaged over the entire alloy. The dispersion of the dissolved nitrogen over the entire magnetostrictive material is obtained based on the results of the line profile analysis due to the EPMA.

That is, when microscopically observing the magnetostrictive material, there tends to occur fluctuation (dispersion) in the nitrogen concentration between the neighborhood of the surface and the inside thereof, and between the neighborhood of the grain boundary and the inside of the grain. Such dispersion of the nitrogen concentration affects adversely on the magnetostriction, and, due to the dispersion of local lattice strain, deteriorates the mechanical reliability. Accordingly, the dispersion of the nitrogen concentration is preferable to be within ± 30 % of the average value, more preferable to be within ± 25 %. The dispersion of the nitrogen concentration, as detailed in the below, can be eliminated by means of homogenizing heat treatment.

In the first giant magnetostrictive material of the present invention, a lattice constant of a grain of a magnetostrictive alloy therein nitrogen is dissolved is preferable to be increased by 0.1 % or more than that of a grain before dissolution of the nitrogen. When the nitrogen is dissolved interstitially, the lattice constant of the grain changes. The change of the lattice constant, in view of an improvement of the Curie temperature, is necessary to be increased by at least 0.1 % or more. When the change of the lattice constant is less than 0.1 %, the increase of the Curie temperature is only slight to be practically ineffective. The change of the lattice constant can be obtained from X-ray diffraction measurements before and after the nitrogen introduction.

Furthermore, the nitrogen diffuses from a surface of material (surface of alloy) toward the inside of the material. Accordingly, in the process of the nitrogen addition treatment, the nitrogen concentration may be extremely excessive in the surface to be likely to cause anomaly in the grain texture at the surface, resulting in damaging mechanical reliability. Such anomalous layer can be a source of defects, a thickness thereof being preferable to be 0.05 mm or less, accordingly. The anomalous layer here means a region where the nitrogen concentration is twice or more the average nitrogen concentration inside of the material.

Oxygen content of the giant magnetostrictive material of the present invention is preferable to be 20000 ppm or less. In the rare earth-transition metal base giant magnetostrictive material, in particular in the giant magnetostrictive material therein nitrogen is interstitially dissolved between crystal lattices, oxygen is an element that adversely affects on magnetostriction. The oxygen is mainly brought in from rare earth raw material or from an atmosphere gas during the heat treatment as an impurity. With an increase of the oxygen content, magnetostriction and mechanical strength deteriorate. Accordingly, it is preferable for the oxygen concentration in the magnetostrictive alloy to be 20000 ppm or less, more preferable to be 15000 ppm or less, still more preferable to be 10000 ppm or less. Furthermore, when the surface of the magnetostrictive alloy is selectively deteriorated by oxygen, the mechanical reliability is damaged. Since an oxide layer or an oxygen rich layer formed on the alloy surface can be a source of defects, a thickness of a region exceeding 3 % in the oxygen concentration is preferable to be 0.05 mm or less.

In addition, contents of fluorine and chlorine as inevitable impurity are preferable to be 200 ppm or less in total thereof. Fluorine and chlorine are elements mainly brought in from the rare earth raw materials to deteriorate the magnetostriction and mechanical reliability. Accordingly, in view of suppressing such characteristics from deteriorating, the content of fluorine and chlorine in the magnetostrictive alloy is preferable to be 200 ppm or less in total thereof. The content of fluorine and chlorine as the impurity is more preferable to be 150 ppm or less in total, still more preferable to be 100 ppm or less.

In the rare earth-transition metal alloy (mother alloy) constituting the first giant magnetostrictive material of the present invention, in addition to the aforementioned nitrogen, at least one kind selected from hydrogen, boron, carbon, phosphorus and silicon may be added. These, without restricting to one added positively, may be one included therein as the impurity. By containing hydrogen, boron, carbon, phosphorus and silicon, the Curie temperature of the giant magnetostrictive material can be further improved in some cases. However, too much inclusion causes lower magnetostriction. Accordingly, the content of these elements is preferable to be in the range of 0.0001 to 3 % by mass in total.

In the present first giant magnetostrictive material, the nitrogen in the range where temperature characteristics and magnetostriction are compatible is interstitially dissolved between the crystal lattice, thereby the nitrogen content present as the nitrogen compound being largely reduced. Accordingly, while maintaining excellent magnetostriction and mechanical reliability, even under an environment exceeding for instance 100°C, such magnetostriction can be fully exhibited.

The first magnetostrictive material of the present invention has the magnetostriction of for instance 200 ppm or more. The magnetostriction is preferable to be 500 ppm or more, more preferable to be 700 ppm. Furthermore, the first magnetostrictive material has the Curie temperature of for instance 400°C or more. The Curie temperature is preferable to be 450°C or more, furthermore preferable to be 500°C or more. That the Curie temperature, which is a critical temperature where ferromagnetism disappears, is high means that even under a high temperature environment, excellent ferromagnetism, that is, excellent magnetostriction can be obtained.

The first giant magnetostrictive material of the present invention is manufactured in the following ways for instance.

First, alloy material essentially consisting of a rare earth element and a transition metal element is prepared. In manufacturing the alloy material, single crystal preparation method such as growth method, unidirectional solidification method, powder metallurgy method, melt quench method, simple casting method (equi-axed), or thin film process can be applied. In the melt quench method, single roll or twin roll method, or gas atomization method and centrifugal quenching method can be used.

To such rare earth-transition metal base alloy material, first, heat treatment is applied to grow grains or to homogenize alloy components. At that time, a heat treatment temperature is preferable to be in the range from 650 to 1200°C. The heat treatment is implemented in an inert atmosphere such as in a vacuum or an inert gas atmosphere. By heat treating the alloy material at the aforementioned temperature to grow grains or to homogenize the alloy components, excellent magnetostriction corresponding to the alloy composition or the like can be obtained with good reproducibility.

Next, nitrogen addition treatment is implemented to dissolve nitrogen in the alloy material after the heat treatment. The nitrogen addition process is implemented by heat treatment in an atmosphere containing for instance nitrogen, or by mechanical alloying in an atmosphere containing nitrogen. Anyway, it is important to implement the nitrogen addition treatment in a temperature region of 600°C or less. By implementing the nitrogen addition treatment in such temperature region, nitrogen compounds such as rare earth nitride or iron nitride due to the added nitrogen can be prevented from occurring. In other words, the added nitrogen can be effectively introduced interstitially between the crystal lattice of the alloy. When the temperature during the nitrogen addition treatment exceeds 600°C, the nitrogen compound is rapidly increased in its amount.

The process of nitrogen addition will be detailed. When applying heat treatment to add nitrogen, rare earth-transition metal base alloy materials prepared by the use of various methods are preferably heat treated in an atmosphere containing nitrogen in the range of temperature from 200 to 600°C. Appropriate heat treatment conditions differ due to the kind of alloy, kind of gas and atmospheric condition such as partial pressure of gas. However, when heat treating at a temperature exceeding 600°C, the nitrogen compound is formed greatly.

On the other hand, as the heat treatment temperature decreases, the nitrogen concentration is controlled with ease. However, when heat treating at a temperature less than 200°C, the nitrogen is contained with difficulty. Furthermore, even if intruding in the alloy, diffusion speed of nitrogen is low to take an extremely longer treatment time. Accordingly, it is not practical to implement the heat treatment at a temperature less than 200°C. The heat treatment is preferably implemented in the temperature range from 350 to 550°C where a reaction can be controlled with ease and an appropriate reaction speed can be obtained.

The heat treatment as the nitrogen addition process is implemented in an atmosphere containing nitrogen. As the atmosphere containing nitrogen, for instance atmosphere of pure nitrogen, atmosphere containing ammonia, atmosphere containing inert gas and nitrogen or ammonia, atmosphere containing ammonia gas and nitrogen and atmosphere containing cyanide can be used. In particular, the atmosphere of pure nitrogen, the atmosphere containing inert gas and nitrogen and the atmosphere containing cyanide are preferably used. By means of such nitrogen addition process, to the rare earth-transition metal base alloy material, the nitrogen in the range from 0.01 to 2.5 % by mass is introduced.

When applying the mechanical alloying method as the nitrogen addition treatment, to the rare earth-transition metal base alloy materials prepared due to the aforementioned various methods, the mechanical alloying is implemented in an atmosphere containing nitrogen at a temperature region less than 600°C. In the mechanical alloying, due to rotation of hard spheres, metal powder is repeatedly milled and compressed as if kneading. At that time, the nitrogen can be included in the alloy. Even in such mechanical alloying process, by setting an atmospheric temperature at 600°C or less, the nitrogen compound can be largely suppressed from forming.

The mechanical alloying with too much mechanical energy can damage magnetostriction. Accordingly, input energy is preferable to be appropriately adjusted. Furthermore, when the mechanical alloying is applied, strain is accumulated in the material, usually heat treatment being implemented to relieve the strain, accordingly. The temperature at that time also is preferable to be 600°C or less. The heat treatment for relieving the strain can be implemented simultaneously in the heat treatment for homogenizing nitrogen described in the below.

In the nitrogen addition process, when a portion of high nitrogen concentration is locally formed in the alloy, the nitrogen compound may be formed, a change of crystal structure may be caused. Accordingly, in order to suppress nonuniformity of the nitrogen concentration from occurring, depending on the kind or state of the material to treat, kind of gas, pressure of gas, mixing ratio of gas and heat treatment temperature and time for nitrogen addition are preferable to be adjusted.

Furthermore, heat treatment is preferably implemented to homogenize nitrogen. That is, after the heat treatment or mechanical alloying for nitrogen addition, it is preferable to implement heat treatment to homogenize the nitrogen in an inert atmosphere at a temperature in the range from 200 to 600°C. Simple addition of nitrogen lacks homogeneity to tend to result in poor magnetostriction. To overcome a local concentration fluctuation of nitrogen that causes the poor magnetostriction, it is preferable to implement heat treatment to diffuse the nitrogen and to relieve strain. More specifically, the heat treatment is implemented in an Ar atmosphere to homogenize. Furthermore, the heat treatments for nitrogen addition and for homogenization may be alternately repeated.

The method for manufacturing giant magnetostrictive material of the present invention comprises a heat treatment process for growing grain and homogenizing alloy components and a nitrogen addition process, and as demands arise, may further comprise a process for molding the alloy material after the heat treatment for homogenizing nitrogen into a desired shape. In the molding process of the alloy material, various kinds of molding methods can be applied. For instance, the alloy powder after heat treatment and nitrogen addition, or one in which the alloy powder is mixed with reinforced fiber such as carbon fiber is molded by the use of a binder such as metal or resin. The alloy powder is sintered after magnetic molding thereof. Alloy pieces (such as flake material and so on) are stacked by the use of hot pressing.

Furthermore, the first giant magnetostrictive material of the present invention may be one in which nitrogen is contained in an alloy thin film obtained by the use of thin film process. Even in such magnetostrictive alloy thin film, by interstitially dissolving the nitrogen into the lattice, the giant magnetostrictive material high in Curie temperature and excellent in magnetostriction can be obtained. As the thin film processes, various kinds of film formation methods such as sputtering method, vacuum deposition method, molecular beam epitaxy (MBE) method, ion plating method, laser deposition method, ion beam deposition method and flush method can be applied. Furthermore, other than implementing the nitrogen addition treatment after film formation, also by introducing nitrogen gas during the film formation, a desired thin film of the magnetostrictive alloy can be obtained.

In the first giant magnetostrictive material of the present invention, specific mode of materials of rare earth-transition metal alloy is not particularly restricted. In the first giant magnetostrictive material, as mentioned in the above, various modes of alloy material can be used, for instance unidirectionally solidified material, single crystal material, melt quench material and integrated one thereof, sintered material due to powder metallurgy, powder pressed material and equi-axed cast material can be cited.

When using anisotropic giant magnetostrictive material is employed, it is preferable for the crystallographic direction to be oriented. More specifically, in the case of the unidirectionally solidified material being used, in grains of 80 % by volume or more of entire material, the crystallographic direction in a direction of an applied magnetic field (direction of which magnetostriction is used) is preferable to orient within ± 45 degrees from {1,1,1} or {1,1,0}. In other words, in 80 % by volume or more of grains of the entire material, {1,1,1} or {1,1,0} direction thereof is preferable to be oriented within ± 45 degrees with respect to the direction of the applied magnetic field (direction of which magnetostriction is used). The oriented grains are more preferable to be 85 % by volume or more of the entire material, still more preferable to be 90 % by volume or more. Furthermore, at that time, the range of the angle is more preferable to be within ± 30 degrees, still more preferable to be within ± 20 degrees.

By employing such unidirectionally solidified material, excellent magnetostriction of the giant magnetostrictive material can be exhibited. Even in the melt quench material, it is preferable to give the similar crystallographic orientation. Furthermore, in the case of unidirectionally solidified material, melt quench material and sintered material being used, an average grain diameter of the alloy material is preferable to be 15 μm or less.

In the case of single crystal being used, the crystallographic orientation in a direction of applied magnetic field (direction of which magnetostriction is used) is preferable to be oriented within ± 45 degrees from {1,1,1} or {1,1,0}. At that time, the range of angle is more preferable to be within ± 30 degrees, still more preferable to be within ± 15 degrees. Thereby, similarly with the unidirectionally solidified material, the magnetostriction of the giant magnetostrictive material can be exhibited.

When the melt quench material is applied in the giant magnetostrictive material of the present invention, it is preferable to use melt quench flake material containing columnar structure grains extending in a thickness direction as a main crystal structure. Such melt quench flake material, by integrating in a state stacked in a direction of thickness, that is in a direction of growth of the columnar grain, is used as the giant magnetostrictive material. This is based on the second giant magnetostrictive material of the present invention.

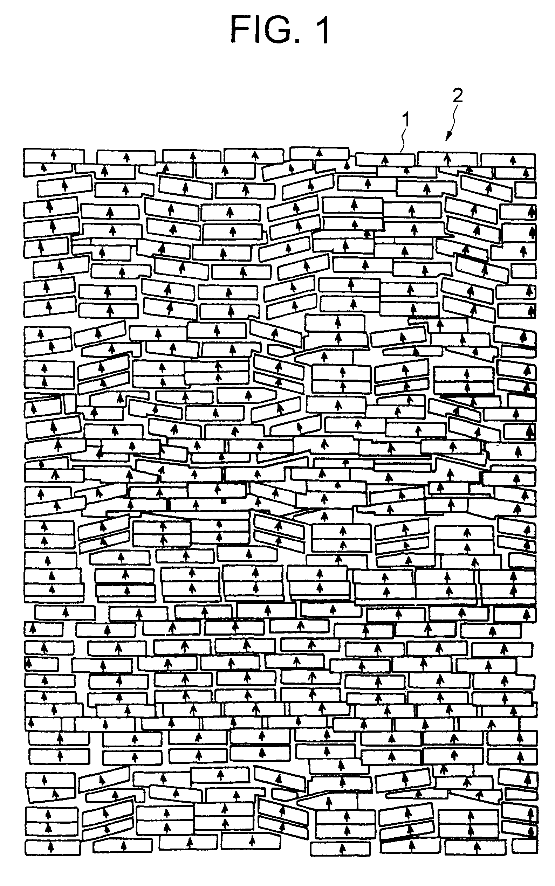

Fig. 1 is a diagram schematically showing a configuration of one embodiment of the second giant magnetostrictive material of the present invention. In the same figure, reference numeral 1 denotes melt quench flake material. Such melt quench flake material 1 is stacked in a thickness direction to integrate in that state. Thus, the giant magnetostrictive material 2 is configured.

The melt quench flake material 1 comprises an alloy consisting essentially of a rare earth element and a transition metal element. The rare earth-transition metal base alloy is specifically explained in the above, for instance an alloy having a composition expressed by formula (1) being used. At that time, the rare earth-transition metal alloy may contain nitrogen or may not contain nitrogen. When the melt quench flake material 1 is prepared from the rare earth-transition metal alloy satisfying the conditions concerning the nitrogen of the first giant magnetostrictive material, as mentioned in the above, excellent temperature characteristics can be obtained.

The melt quench flake material 1 is obtained by quenching alloy melt including a rare earth element and a transition metal element by means of single roll method. The melt quench method is one by which metal melt is quenched by a cooling speed larger than that of the casting method to solidify. The method is characterized in that grains are finely powdered, segregation can be removed, solubility limit of solute can be expanded, metastable crystalline state is formed, and amorphous material is formed.

In the present invention, when the alloy melt consisting essentially of a rare earth element and a transition metal element is quenched to form flake, the columnar structure grow in a thickness direction, furthermore the grain growth direction of the columnar structure being convenient for the magnetostriction. The present invention conveniently utilizes this property. In the melt quench flake material 1, the crystallographic direction large in the magnetostriction in a thickness direction tends to grow. The melt quench flake material 1 is preferable to contain the columnar structure grains as mentioned above by 70 % by volume or more. In other words, it is preferable to employ the melt quench flake material 1 in which a volume ratio of equi-axed grains to columnar structure grains is in the range from 0:100 to 30:70. When the volume ratio of the columnar structure is less than 70 % by volume, magnetostriction of the rare earth-transition metal alloy may not be fully utilized.

The giant magnetostrictive material 2 shown in Fig. 1 is obtained by stacking the melt quench flake material 1 as mentioned above in a thickness direction thereof to integrate in that state. In the drawing, an arrow mark is a grain growth direction of the melt quench flake material 1, by applying a magnetic field in this direction, large magnetostriction being obtained.

The crystallographic direction in a thickness direction of the columnar structure that mainly constitute the melt quench flake material 1 is preferable to be approximate {1,1,1} or approximate {1,1,0}. These crystallographic directions are ones large in magnetostriction. As the crystallographic directions of the columnar structure deviate from {1,1,1} or {1,1,0}, the magnetostriction in a direction to use decreases. The crystallographic direction of the columnar structure here, when the columnar structure grow in a direction of {1,1,1} or {1,1,0}, needs only for such grain growth direction to be within ± 45 degrees with respect to the thickness direction of the flake material 1. The melt quench flake material 1 needs only to contain the columnar structure satisfying such conditions by 75 % by volume or more.

The grain growth direction (for example, {1,1,0} or {1,1,1}) of the aforementioned columnar structure is more preferable to be within ± 30 degrees with respect to the thickness direction of the flake material 1, still more preferable to be within ± 20 degrees. Furthermore, the volume ratio of the columnar structure satisfying the above crystallographic direction conditions is more preferable to be 80 % or more by volume, still more preferable to be 85 % or more, desirably to be 90 % or more.

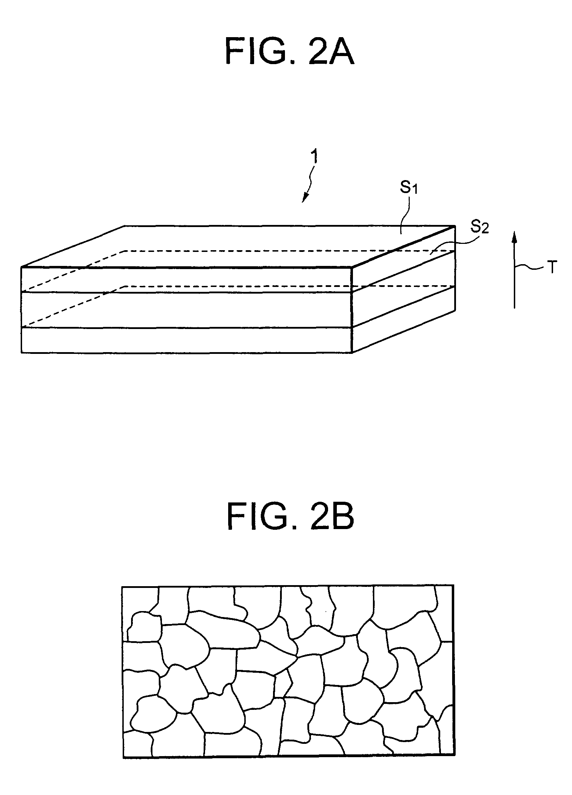

An angle that the thickness direction of the melt quench flake material 1 forms between the grain growth direction is measured by the use of EBSD device (Electron Back Scattering Diffraction). That is, as shown in Fig. 2A, from the flake material 1 a plurality of sections $S_1$, $S_2$ and so on perpendicular to the thickness direction thereof (direction of arrow T) is shaved. With the respective sections $S_1$, $S_2$, and so on as measuring objects, as shown in Fig. 2B, for each grain, the angle that the thickness direction forms between the grain growth direction is measured. The angle that the thickness direction of the melt quench flake material 1 forms between the grain growth direction denotes an average value of these measurements.

An angle that, in the above unidirectionally solidified material, the crystallographic direction forms between a perpendicular (direction of which magnetostriction is used) of a plane of action thereof is similarly measured by the use of the EBSD. That is, with a plane of action of the giant magnetostrictive material and a plurality of sections parallel therewith as measuring objects, for each grain, the crystallographic direction is measured. The angle that in the unidirectionally solidified material, the crystallographic direction forms between the direction of which magnetostriction is used denotes an average value of these measurements.

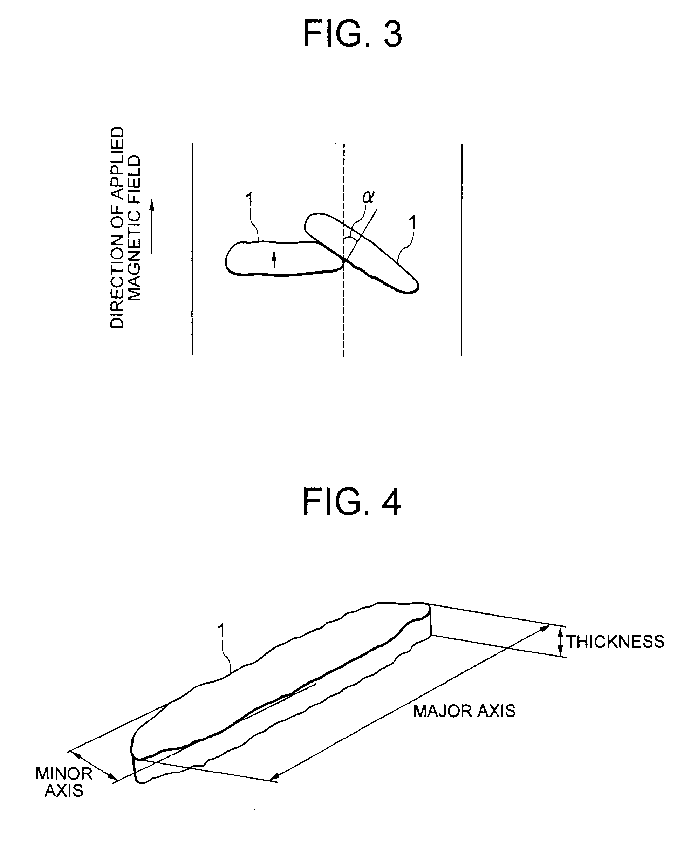

The stacked giant magnetostrictive material 1 shown in Fig. 1 is preferable that, in the measurement with X-ray diffractometer (XRD), a ratio of a peak intensity of a plane of crystallographic orientation (crystallographic orientation of columnar grain) of the melt quench flake material 1 to that of a reference peak is 1.5 times or more that in random orientation. Furthermore, even when the melt quench flake material 1 is disorderly stacked, as shown in Fig. 3, there is not a particular problem when an angle of misalignment α is less than 30 degrees. The flake material 1 that is disorderly stacked is preferable to be 5 % by volume or less of an entire volume.

An average thickness of the melt quench flake material 1 is preferable to be in the range from 10 to 1,000 μm. When the average thickness is less than 10 μm, at the stacking to integrate, the flake material 1 tends to be cracked, the crystallographic orientation of the columnar structure being likely to be disturbed. On the other hand, when the average thickness exceeding 1000 μm, the melt quench flake material 1 becomes difficult to stack. Accordingly, the crystallographic orientation of the columnar structure is likely to be disturbed. In view of uniformity of the cooling speed and crystallographic orientation, the thickness of the melt quench flake material 1 is preferable to be uniform. The dispersion of the thickness of the melt quench flake material 1 is preferable to be within ± 20 % of the average thickness, more preferable to be within ± 10 % of the average thickness.

The average thickness of the melt quench flake material 1 is measured by means of a point micrometer (at tip end radius R = 0.5). The thickness of the portion that excludes a range of 0.5 mm from an edge face in a width direction of the flake material 1 is randomly measured at 20 points or more in the width and length directions. The obtained measurements are averaged to obtain the average thickness. The dispersion of the thickness is a ratio of a difference between the maximum value and the average value to the average value, and a ratio of a difference between the average value and the minimum value to the average value. The average thickness of the melt quench flake material 1 is preferable to be in the range from 30 μm or more and 600 μm or less, more preferable to be in the range from 50 μm or more and 500 μm or less.

Furthermore, shape (dimension) of the melt quench flake material 1 is preferable in the ranges of (minor axis of flake>3×average thickness of flake) and (major axis of flake)/(minor axis of flake) = 1 to 20. It is preferable to contain the melt quench flake material 1 of such shape 70 % by mass or more. A perspective view of a single melt quench flake material 1 is shown in Fig. 4. By the use of the melt quench flake material 1 having the shape as mentioned in the above, the flake material 1 can be more easily stacked with planes aligned. Thereby, the orientation of the columnar structure can be enhanced.

In the giant magnetostrictive material 2 shown in Fig. 1, in a direction of arrow, that is, in a thickness direction (grain growth direction of columnar grain) of the melt quench flake material 1, a magnetic field is applied. By making use of the magnetostriction in this direction, a magnetostrictive actuator or a magnetostrictive sensor is configured. As mentioned in the above, in the columnar structure mainly constituting the melt quench flake material 1, the crystallographic direction larger in the magnetostriction is the grain growth direction. Accordingly, by stacking such melt quench flake material 1 aligned in the thickness direction, large magnetostriction can be assuredly utilized. That is, the giant magnetostrictive material 2 excellent in the magnetostriction can be obtained with reproducibility. The giant magnetostrictive material 2 has the magnetostriction of 200 ppm or more for instance. The magnetostriction is more preferable to be 300 ppm or more, still more preferable to be 500 ppm or more, desirably to be 700 ppm or more.

Furthermore, in the giant magnetostrictive material 2 consisting of stacked/integrated material of the melt quench flake material 1, based on an orientation state of the columnar structure grains and a stacking state of the flake material 1, the crystallographic direction of the entire material can be arranged. Accordingly, waste of the material as in the existing unidirectional solidified material can be saved. Thereby, manufacturing cost of the giant magnetostrictive material can be largely reduced. The melt quench flake material 1, being small in a specific surface area in comparison with that of fine powder used in the existing powder metallurgy as raw material powder, can suppress the magnetostriction from lowering due to oxidation or the like. Thereby, manufacture yield as well as the magnetostriction can be improved. An improvement of the manufacture yield contributes to reduce the manufactures' cost of the giant magnetostrictive material.

The giant magnetostrictive material 2 shown in Fig. 1 is manufactured for instance in the following ways.

First, melt essentially consisting of a rare earth element and a transition metal element is quenched to prepare melt quench flake material. More specifically, by means of the melt quench process, the flake material having desired columnar structure grains and grain growth orientation is prepared, the prepared flake material being milled to an extent of several tens μm to several tens mm as demands arise. In the present invention, by making use of shape effect of such flake material, a necessary state of crystallographic direction is obtained. Accordingly, there is no need to form in fine powder as in the magnetic molding. Furthermore, it is adversely affected by oxidation with difficulty.

In the melt quench process, single or twin roll method can be applied. At that time, roll material, though preferable to be Cu base alloy in view of thermal conductivity, may be Fe base alloy. A peripheral speed of the roll, being dependent on wettability between the roll and melt, distance of contact between the melt and roll and water-cooled state of the roll, cannot unconditionally be decided. However, when it is too fast, equi-axed grains result greatly to be unfavorable. On the other hand, when it is too late, desired orientation can be obtained with difficulty.

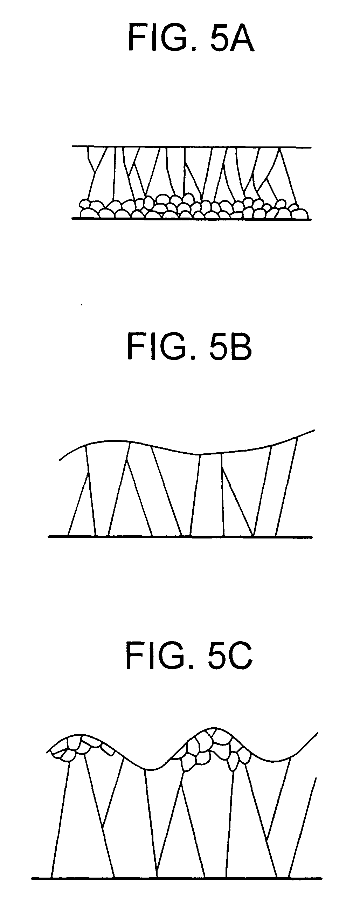

More specifically, as shown in Fig. 5A, when a cooling speed is fast, that is, when being cooled too much, equi-axed grains result to be the flake containing equi-axed grains in a portion thin in the thickness. On the other hand, when the cooling speed is too large, as shown in Fig. 5C, the thickness of the flake becomes larger to result in distorted section, at the distorted portion the equi-axed grains being formed. Contrary thereto, by selecting an appropriate cooling speed, as shown in Fig. 5B, flakes mainly consisting of the columnar structure and having uniform thickness can be obtained.

In the manufacturing process of the melt quench flake material, it is preferable that the cooling condition or the condition of milling after the quenching is controlled for the dimension of 70 % by mass or more of the flake material to be (minor axis of flake > 3×(average thickness of flake) and (major axis of flake)/(minor axis of flake) = 1 to 20.

The melt quench flake material, after the heat treatment for grain growth and/or homogenization, is preferable to be stacked/integrated. The heat treatment is preferable to be implemented in the temperature range from 800 to 1200°C. By heat treating the melt quench flake material at such temperatures, the magnetostriction can be further improved. The heat treatment for grain growth and/or homogenization may be implemented after the stacking to integrate. Furthermore, the homogenization heat treatment has simultaneously an effect to relieve residual strain.

Next, by making use of the shape effect of the aforementioned melt quench flake material, as shown in Fig. 1, the melt quench flake material 1 is stacked with the thickness direction aligned. In stacking the flake material 1, by giving vibration to the flake material 1, crystallographic orientation, that is, orientation in a grain growth direction of the columnar structure may be enhanced. The stacked flake material 1 is integrated by means of sintering method such as for instance hot pressing or spark plasma sintering. Sintering temperature is preferable to be in the range from 800 to 1200°C. The flake material 1 may be integrated by means of a resinous binder.

In sintering the melt quench flake material 1 to integrate, as a sintered additive, fine powder of the same composition with the flake material, or fine powder that forms an intended component by fusing with the flake material may be used. An amount to add of such sintered additive is preferable to be 30 % by mass or less with respect to the flake material 1. For the sintered additive, fine powder thereto a depressing element of melting point such as B, C, Si or the like is added is preferably used. Furthermore, when implementing hot pressing or spark plasma sintering, there may occur a disordering of the crystallographic direction at a portion contacting with a mold. After cutting out such a portion, it is preferable to use as the magnetostrictive material.

In the aforementioned method for manufacturing giant magnetostrictive material, by means of the melt quench process, as by the unidirectional solidification process, flake-like material in which crystallographic direction is aligned in the direction of flake thickness is prepared. The flake-like material is stacked in a mold in the direction of flake thickness by making use of the shape effect. Furthermore, a stacked body of such flake material is formed into a near net bulk body by the use of for instance hot pressing or spark plasma sintering. Accordingly, the giant magnetostrictive material of low oxygen concentration, that is, the giant magnetostrictive material of excellent magnetostriction can be provided at low cost.

The giant magnetostrictive material of the present invention is expected to be used in versatile fields such as survey field, civil engineering and construction field, precision machinery field, industrial machinery field, electric and electronic field, resource and energy field, aerospace and aircraft and automobile field and medical field.

For instance, in the survey field, the present giant magnetostrictive material can be utilized in underground survey for oil field or water leakage, marine tomography for marine survey or sonar (sound navigation ranging) for submarine search. In the civil engineering and construction field, it is utilized in active vibration control such as vibration proof of buildings or vibration isolation of semiconductor manufacturing devices, and in active sound insulation for anti-noise measure. In the precision machinery field, it is utilized in auto focussing of cameras, alignment of optical mirrors, and linear motors.

In the industrial machinery field, it is utilized in miniature positioners for precision alignment, drivers of robot arm, ultrasonic cleansing apparatuses, active vibration isolation, and hydraulic pumps. In the electric and electronic field, it is expected to be utilized in vibrators for acoustic speakers, surface acoustic wave filters, and portable telephones and fine adjustment actuators for magnetic head. In the resource and energy field, the use in power generation, in the field of aerospace, aircraft and automobile, the use in fuel injectors, high speed valve, locking unit, variable rotor blades, knocking sensors and torque sensors, in the medical field, the use in hearing aide and miniature pumps for biological use are expected.

The devices therein the giant magnetostrictive material of the present invention is used are mainly divided into actuators and sensors. That is, the present magnetostrictive material is used for drivers of magnetostrictive actuators, or for sensors of magnetostrictive sensors.

The magnetostrictive actuator of the present invention comprises the giant magnetostrictive material of the present invention as driver. The magnetostrictive actuator having for instance the giant magnetostrictive material of the present invention comprises driving force generating means, a movable member and magnetic field applying means. Here, in the driving force generating means, one end in a direction to use magnetostriction of the giant magnetostrictive material is solidly fixed. The movable member is solidly fixed to the other end of the driving force generating means and movable in a direction of displacement of the giant magnetostrictive material. The means for applying a magnetic field applies a magnetic field to the giant magnetostrictive material. In the magnetostrictive actuator using anisotropic material, the magnetic field is applied in a direction of crystallographic orientation of the giant magnetostrictive material, the magnetostriction in this direction (crystallographic direction of grain) being utilized as a driving force.

When the present giant magnetostrictive material is used in an actuator, as the rare earth element Tb is mainly used. As specific examples of the actuator, a fuel injection valve used in an internal engine of an automobile, hydraulic components, acoustic equipment such as a speaker and a microphone, machine tools, and a precision positioning device can be cited.

In particular, the fuel injection valve therein the present magnetostrictive material is employed is useful. For the fuel injection valve used in an engine of an automobile, heat resistance up to 150 to 200°C is required. Accordingly, so far, a piezoelectric element that varies a volume according to an applied voltage has been mainly used. However, since the piezoelectric element requires a voltage of approximate 1000 V, a booster is necessary. By contrast, when the present giant magnetostrictive material is used, not only the giant magnetostriction is exhibited under a high temperature environment, but also a voltage of only approximate several volts is required. As a result, there is an effect that a booster is not necessary.

The magnetostrictive sensor of the present invention comprises the present giant magnetostrictive material as a sensor. The magnetostrictive sensor comprises a sensor portion having for instance the giant magnetostrictive material of the present invention and a detector (for instance, detector coil) detecting change of strain based on stress applied on the giant magnetostrictive material as change of the magnetostriction. When the present giant magnetostrictive material is applied in the sensor, $SmFe_2$ system alloys are mainly used. As specific examples of the sensor, strain sensor, torque sensor, vibration sensor and acceleration sensor can be cited.

Next, specific embodiments of the present invention and evaluation results thereof will be described.

Embodiment 1

Alloy material of a composition of $Tb_{0.5}Dy_{0.5}(Fe_{0.9}Mn_{0.1})_{1.95}$ is prepared by means of unidirectional solidification process, after homogenizing heat treatment at a temperature of 900°C, a test chip of a dimension of $10 \times 5 \times 3$ mm being cut out. The test pieces undergo nitrogen addition treatment in an atmosphere of nitrogen at the respective temperatures of 480°C, 530°C and 580°C for 4 h, and furthermore undergoing homogenizing heat treatment at the same temperatures respectively in an atmosphere of Ar for 10 h. As to crystallographic orientation of these unidirectionally solidified materials, direction of crystallographic orientation of 90 % or more by volume is within ± 30 degrees from {1,1,0}.

Nitrogen contents (total nitrogen content) of the respective alloy materials after the nitrogen addition treatment are measured by means of LECO analysis, measurements being 0.1 % by mass, 1.0 % by mass and 1.5 % by mass, respectively. Contents of nitrogen (average value) dissolved interstitially in the respective alloy materials are measured by means of EPMA, being 0.099 % by mass, 0.99 % by mass and 1.47 % by mass, respectively. Furthermore, presence of nitride is checked due to X-ray diffractometer to be found that in the test piece of which nitrogen content (total nitrogen content) is 1.5 % by mass, nitride is confirmed to form. However, when, from a value that is obtained by subtracting the interstitially dissolved nitrogen content from the total nitrogen content, a ratio of the nitrogen content contained in the nitride to the total nitrogen content is calculated, it is found to be such slight value as 0.02.

Next, magnetostriction at room temperature of the respective nitrogen added materials and untreated alloy material (reference material) are compared. As a result, it was found that the magnetostriction of the nitrogen added materials are 97 %, 58 % and 55 %, respectively, with respect to that of the untreated material. When X-ray diffraction of the nitrogen added materials is carried out, it was discovered that though a little change in the lattice constant was found, the diffraction pattern was identical with that of the untreated material.

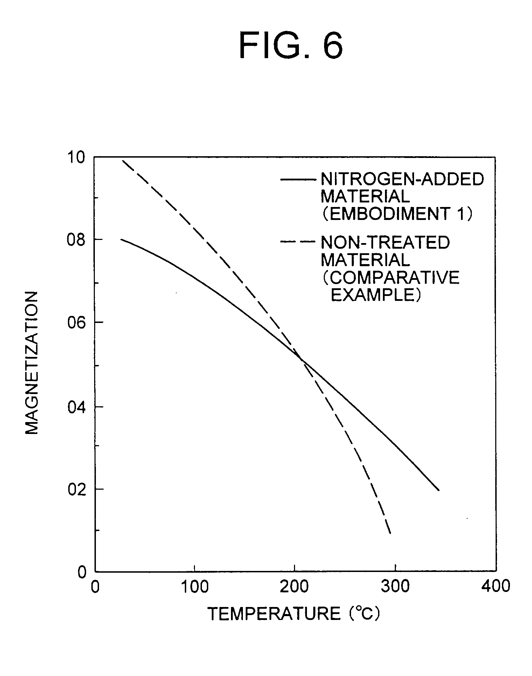

Furthermore, with increasing the temperature magnetization of the nitrogen added material (specimen of which total nitrogen content is 1.4 % by mass) and the untreated reference material are measured to compare temperature dependence of the magnetization. Fig. 6 shows results thereof. As evident from Fig. 6, whereas the magnetization of the untreated reference material at 300°C is 10 % or less of that at room temperature, that of the nitrogen added material at 300°C maintains the value of 30 % or more of that at room temperature. A change rate (temperature coefficient) of the magnetization up to the temperature of 300°C of the nitrogen added material is approximately one half that of the untreated material. In single crystal and powder metallurgy materials, the similar effect is found.

Furthermore, by the process identical with the above, to alloy materials of which compositions are shown in Table 1 respectively, the nitrogen addition treatment is applied, magnetostriction and Curie temperatures thereof are measured. These results are shown together in Table 1.

Table 1

| No. | Composition (atomic ratio) | Nitrogen content (% by mass) | Ratio of nitrogen in compound | Magnetostriction (ppm) | Curie temperature |
|---|---|---|---|---|---|
| 1 | $Tb_{0.5}Dy_{0.5}(Fe_{0.9}n_{0.1})_{1.95}$ | 1.5 | 0.04 | 630 | Above 450°C |
| 2 | $Tb_{0.3}Dy_{0.7}Fe_{2.1}$ | 0.1 | 0.01 | 500 | Above 420°C |
| 3 | $Tb_{0.27}Dy_{0.73}(Fe_{0.9}Mn_{0.05}Zn_{0.05})_2$ | 2 | 0.03 | 650 | Above 470°C |
| 4 | $Tb_{0.4}Dy_{0.5}Ho_{0.1}(Fe_{0.9}Mn_{0.05}Al_{0.05})_{1.9}$ | 0.5 | 0.01 | 580 | Above 420°C |
| 5 | $Tb_{0.4}Dy_{0.5}Ho_{0.1}(Fe_{0.9}Co_{0.02}Cr_{0.08})_{1.7}$ | 1.5 | 0.03 | 500 | Above 450°C |
| 6 | $Tb_{0.2}Nd_{0.1}Dy_{0.7}(Fe_{0.9}Ni_{0.05}Zr_{0.05})_{1.7}$ | 2.5 | 0.03 | 480 | Above 470°C |
| 7 | $Tb_{0.4}Pr_{0.1}Dy_{0.5}(Fe_{0.6}Co_{0.4})_{2.2}$ | 2 | 0.03 | 600 | Above 460°C |
| 8 | $Tb_{0.6}Ho_{0.4}(Fe_{0.9}Co_{0.06}Ni_{0.02}Mo_{0.02})_2$ | 1 | 0.02 | 480 | Above 440°C |
| 9 | $Tb_{0.6}Pr_{0.4}(Fe_{0.9}Co_{0.06}Ni_{0.02}Ta_{0.02})_2$ | 2.2 | 0.03 | 480 | Above 450°C |
| 10 | $Tb_{0.6}Ho_{0.3}Pr_{0.1}(Fe_{0.98}Nb_{0.02})_{1.8}$ | 0.3 | 0.01 | 500 | Above 420°C |
| 11 | $Tb_{0.3}Sm_{0.1}Dy_{0.6}(Fe_{0.9}Mo_{0.05}Ga_{0.05})_{1.9}$ | 1 | 0.02 | 610 | Above 420°C |
| 12 | $Sm_{0.9}Dy_{0.1}(Fe_{0.9}Ni_{0.05}Mn_{0.05})_2$ | 1.2 | 0.02 | -660 | Above 430°C |
| 13 | $Sm_{0.9}Er_{0.05}Pm_{0.05}(Fe_{0.95}Al_{0.05})_{1.95}$ | 0.6 | 0.01 | -600 | Above 420°C |
| 14 | $Sm_{0.9}Ho_{0.05}Pm_{0.05}(Fe_{0.95}Ta_{0.05})_{1.9}$ | 2 | 0.03 | -600 | Above 440°C |
| 15 | $Sm_{0.95}Yb_{0.05}(Fe_{0.8}Mn_{0.1}Ge_{0.1})_{1.7}$ | 0.01 | 0 | -580 | Above 420°C |

Table 1   (continued)

| No. | Composition (atomic ratio) | Nitrogen content (% by mass) | Ratio of nitrogen in compound | Magnetostriction (ppm) | Curie temperature |
|---|---|---|---|---|---|
| 16 | $Sm_{0.95}Er_{0.05}(Fe_{0.8}Co_{0.2})_{1.8}$ | 1 | 0.03 | -600 | Above 430°C |
| 17 | $Sm_{0.95}Pm_{0.05}$ $(Fe_{0.9}Cu_{0.1})_{1.8}$ | 0.8 | 0.03 | -650 | Above 400°C |
| 18 | $Sm_{0.95}Ho_{0.05}$ $(Fe_{0.98}W_{0.02})_2$ | 1 | 0.03 | -600 | Above 500°C |

As obvious from Table 1, similarly with the alloy (No.1) of the aforementioned Embodiment 1, also of the respective giant magnetostrictive alloys of Nos. 2 to 18, improved magnetostriction and high Curie temperatures are obtained.

Comparative Example 1

To the same test piece with Embodiment 1, the nitrogen addition treatment is implemented in a nitrogen gas atmosphere at a temperature of 620°C, thereafter the homogenizing heat treatment being carried out in an atmosphere of Ar at a temperature of 530°C. The nitrogen content (total nitrogen content) and the content of interstitially dissolved nitrogen (average value) of the alloy material after the nitrogen addition treatment are measured similarly with Embodiment 1. As a result, it is found that the total nitrogen content is 2.6 % by mass and the average value of the interstitially dissolved nitrogen is 2.2 % by mass. Furthermore, from the X-ray diffraction, it is confirmed that the nitride is formed. The ratio of the nitrogen content contained in the nitride to the total nitrogen content is 0.15.
The magnetostriction of the material due to Comparative Example 1 is measured at room temperature, resulting in no giant magnetostriction. Furthermore, from the result of X-ray diffraction, a crystal structure is confirmed to be different from that of the untreated material.

Comparative Example 2

To the test piece same with Embodiment 1, the nitrogen addition treatment is implemented in a nitrogen gas atmosphere at a temperature of 530°C for 24 h, thereafter the homogenizing heat treatment being carried out in an atmosphere of Ar at a temperature of 530°C for 10 h. The nitrogen content (total nitrogen content) and the content of interstitially dissolved nitrogen (average value) of the alloy material after the nitrogen addition treatment are measured similarly with Embodiment 1. As a result, it is found that the total nitrogen content is 2.65 % by mass and the average value of the interstitially dissolved nitrogen is 2.39 % by mass. Furthermore, from the X-ray diffraction, it is confirmed that the nitride is formed. The ratio of the content of nitrogen contained in the nitride to the total nitrogen content is 0.1. The magnetostriction of the material due to Comparative Example 2 is measured at room temperature. It is found that the magnetostriction decreases to 14 % of that of the untreated material.

Embodiment 2

As isotropic magnetostrictive material, an alloy of a composition of $SmFe_2$ is prepared due to ordinary casting process. To the alloy material, the homogenizing heat treatment is applied at a temperature of 900°C. Thereafter, a test piece of a dimension of $10\times5\times3$ mm is cut out. To the test piece, the nitrogen addition treatment is implemented in a nitrogen gas atmosphere at a temperature of 500°C for 4 h, thereafter the homogenizing heat treatment being carried out in an atmosphere of Ar at the same temperature for 10 h. The nitrogen content (total nitrogen content) and the content of interstitially dissolved nitrogen (average value) of the alloy material after the nitrogen addition treatment are measured similarly with Embodiment 1. As a result, it is found that the total nitrogen content is 1.4 % by mass and the average value of the interstitially dissolved nitrogen is 1.37 % by mass. From these values, the ratio of the nitrogen content present as the nitride to the total nitrogen content is found to be 0.02.
Magnetostriction at room temperature of the aforementioned nitrogen added material and untreated alloy material (reference material) are compared. As a result, it was found that the magnetostriction of the nitrogen added material is 123 % with respect to that of the untreated material. When X-ray diffraction of the nitrogen added material is carried out, it was found that though a little change in the lattice constant was found, the diffraction pattern was identical with that of the untreated material.

Next, with increasing the temperature, temperature variations of the magnetization of the nitrogen added material and the untreated reference material are measured to compare and obtain the Curie temperature. As a result, whereas the value of the magnetization of the untreated reference material at 400°C is 25 % or less of that at room temperature, the nitrogen added material maintains 45 % or more at 400°C of that at room temperature. Up to 300°C, a temperature change rate (temperature coefficient) of the magnetization of the nitrogen added material is approximately one half that of the untreated material.

Embodiment 3

To the test piece same with Embodiment 1, the nitrogen addition treatment is implemented in a nitrogen gas atmosphere at a temperature of 530°C for 4 h, thereafter the homogenizing heat treatment being applied at the same temperature in an Ar gas atmosphere for 0, 2, 4, 7 and 10 h, respectively. The nitrogen contents (total nitrogen content) and the contents of interstitially dissolved nitrogen (average value) of the respective alloy materials are measured similarly with Embodiment 1. The total nitrogen contents are found to be 1.1, 1.08, 1.03, 1.02 and 1.0 % by mass, respectively. The average values of the interstitially dissolved nitrogen are 1.08, 1.06, 1.01, 1.00 and 0.98 % by mass, respectively. From these values, the ratios of the contents of nitrogen present as the nitride to the total nitrogen content are obtained to be 0.02, 0.02, 0.02, 0.02 and 0.02, respectively.
Next, the dispersions to the average values of the nitrogen contents dissolved interstitially in the aforementioned respective test pieces are measured by means of EPMA. The measuring test pieces are equally divided in two along a longer direction, in a direction of a dimension of 3 mm the line profile analysis due to EPMA being carried out from a surface of the test piece toward the center thereof. The dispersions with respect to the average values of the interstitially dissolved nitrogen content are 38, 31, 23, 15, and 5 %, respectively. The magnetostriction of these test pieces at normal temperature are 5, 18, 33, 45 and 55 %, respectively with respect to that of the untreated material. From these measurements, it is found that the dispersion to the average value of the dissolved nitrogen content is preferable to be within ± 30 %.

Embodiment 4

To the test piece same with Embodiment 1, the nitrogen addition treatment is implemented in a nitrogen gas atmosphere at a temperature of 480°C for 48 h, thereafter the homogenizing heat treatment being carried out in an atmosphere of Ar at the same temperature. The nitrogen content (total nitrogen content) and the content of interstitially dissolved nitrogen (average value) of the test piece are measured similarly with Embodiment 1. As a result, it is found that the total nitrogen content is 2.3 % by mass and the average value of the interstitially dissolved nitrogen is 2.3 % by mass. Furthermore, from the X-ray diffraction, it is not confirmed that the nitride is formed. The ratio of the nitrogen content present as the nitride to the total nitrogen content is essentially zero. The magnetostriction of the test piece is 27 % to that of the untreated material at room temperature. Furthermore, the Curie temperature is 750°C.

Embodiment 5

To the test piece same with Embodiment 1, the nitrogen addition treatment is implemented in an atmosphere of a gas mixture of ammonia/nitrogen (volume ratio:1/20) at a temperature of 420°C for 2 h, thereafter the homogenizing heat treatment being carried out in a vacuum atmosphere at a temperature of 480°C for 10 h. The nitrogen content (total nitrogen content) and the content of interstitially dissolved nitrogen (average value) of the test piece are measured similarly with Embodiment 1. As a result, it is found that the total nitrogen content is 2.0 % by mass and the average value of the interstitially dissolved nitrogen is 1.99 % by mass. The ratio of the content of nitrogen existing as the nitride to the total nitrogen content is 0.005. The alloy material contains hydrogen by 0.01 % by mass. The value of the magnetostriction of the test piece is 27 % to that of the untreated material at room temperature. Furthermore, the Curie temperature is 700°C.

Embodiment 6

To the test piece same with Embodiment 1, the nitrogen addition treatment is implemented in an atmosphere of a gas mixture of nitrogen/argon (volume ratio:5/1) at a temperature of 530°C for 5 h, thereafter the homogenizing heat treatment being carried out in an Ar atmosphere at a temperature of 530°C for 10 h. The nitrogen content (total nitrogen content) and the content of interstitially dissolved nitrogen (average value) of the test piece are measured similarly with Embodiment 1. As a result, it is found that the total nitrogen content is 1.7 % by mass and the average value of the interstitially dissolved nitrogen is 1.65 % by mass. The ratio of the content of nitrogen existing as the nitride to the total nitrogen content is 0.03. The magnetostriction of the test piece is 42 % to that of the untreated material at room temperature. Furthermore, the Curie temperature is 650°C.

Embodiment 7

An alloy ribbon of a composition $SmFe_x$ (x = 1.5 to 2.5) is prepared by means of single roll melt quench process under conditions of roll peripheral speed of 5 to 50 m/sec and nozzle diameter of 0.5 to 1.0 mm. A grain diameter of the prepared ribbon is 10 nm to 200 μm. The alloy ribbon undergoes the homogenizing heat treatment at a temperature in the range of 700 to 900°C. Thereafter, in a nitrogen atmosphere of 500°C, the nitrogen addition treatment is applied, followed by milling to 106 μm or less.

Next, the aforementioned alloy powder after the nitrogen addition treatment and liquid epoxy resin are mixed and kneaded in a state diluted by a solvent, followed by volatilization of the solvent in a vacuum vessel. The mixture is compressed to mold, followed by curing the resin at a temperature of 150°C to obtain a green compact having a density of 78 % by volume ratio.

In comparison with one obtained by the ordinary casting process, a magnitude of a magnetic field necessary to saturate the magnetostriction is confirmed to improve by 50 % at the most. In the case of the grain diameter being 15 μm or more, it is confirmed that it takes a longer time to homogenize and an effect to reduce the magnitude of a magnetic field necessary to saturate the value of magnetostriction becomes extremely small.

Embodiment 8

An alloy ingot of a composition $SmFe_x$ (x = 1.5 to 2.5) is prepared by means of casting process. The alloy material, after the homogenizing heat treatment at a temperature of 900°C, milled to 10 μm or less by means of a jet mill. With the alloy powder, compression molding is implemented, followed by sintering in an argon atmosphere. When the nitrogen addition treatment is applied to the obtained sintered body in a nitrogen atmosphere of 500°C, the magnetostriction approximately the same with that of one prepared due to the ordinary casting process is obtained. The time necessary for the nitrogen addition treatment is confirmed to be approximately 70 % to that of one prepared due to the ordinary casting process.

Furthermore, with alloy powder such as $Tb_{0.3}Dy_{0.7}Fe_2$ in which magnetic anisotropy is enhanced as a base, other raw materials are mixed therewith to obtain an intended composition, thereafter, due to magnetic molding and sintering, orientation being enhanced. In the alloy, the similar effect is observed.

Embodiment 9

An alloy ingot of a composition $SmFe_x$ (x = 1.5 to 2.5) is prepared by means of casting process. The alloy material, after the homogenizing heat treatment at a temperature of 900°C, is milled to 250 μm or less by means of a hammer mill. Thereafter, in a nitrogen atmosphere, to the obtained alloy powder the nitrogen addition treatment is applied in a nitrogen atmosphere of 500°C. Thereafter, the powder and liquid epoxy resin are mixed and kneaded in a diluted state by a solvent, followed by volatilization of the solvent in a vacuum vessel. The mixture is compressed to mold, followed by curing the resin at 150°C, thus obtaining a green compact of a density of 83 % by volume ratio. The magnetostriction is 75 % to that of one obtained by the ordinary casting process.

Embodiment 10

An alloy ingot of a composition $SmFe_x$ (x = 1.5 to 2.5) prepared by means of casting process is coarsely milled to 250 μm or less, followed by mechanical alloying process in a gas mixture of ammonia gas/nitrogen to obtain powder of 10 μm or less. To the obtained powder, the stress relieving heat treatment is applied in an argon atmosphere. The total nitrogen content after the heat treatment is 0.5 % by mass and the average value of interstitially dissolved nitrogen content is 0.485 % by mass. A ratio, obtained from these values, of the content of nitrogen present as the nitride to the total nitrogen content is 0.03. Similarly with Embodiment 9, a green compact is prepared. The magnetostriction is 58 % to that of one obtained by the ordinary casting process.

Embodiment 11

An alloy piece (thickness: 100 to 300 μm) of a composition of $Tb_{0.5}Dy_{0.5}(Fe_{0.9}Mn_{0.1})_{1.95}$ is prepared by means of single roll melt quench process called strip casting process. The obtained alloy piece, though having a little chill grain on a roll contact face, essentially consists of columnar structure extending in a thickness direction. The alloy piece is cut out into a magnitude of 10 mm or less, followed by stacking in a thickness direction in a mold of a hot press, thereafter followed by hot pressing at a temperature of 1000°C to obtain a cylindrical sample of a diameter of 10 mm and a length of 20 mm.

The above cylindrical sample, after the homogenizing heat treatment at a temperature of 800°C, is measured of the magnetostriction. The value approximately comparable with that of the unidirectionally solidified material is obtained. Next, to the above sample after the nitrogen addition treatment in a nitrogen gas atmosphere at a temperature of 480°C, the homogenizing heat treatment is followed in an Ar atmosphere at the same temperature. The total content of nitrogen and the average content of interstitially dissolved nitrogen after the nitrogen addition treatment are 1.5 % by mass and 1.47 % by mass, respectively. A ratio, obtained from these values, of the content of nitrogen present as the nitride to the total content of nitrogen is 0.02.

Next, at room temperature, the magnetostriction of the aforementioned nitrogen added material is compared with that of the untreated material. The value of the nitrogen added material is 72 % of that of the untreated material. In addition, Curie temperature is 750°C.

Embodiment 12

To each of alloys of the respective compositions of $Tb_{0.5}Dy_{0.5}(Fe_{0.9}Mn_{0.1})_{1.95}$ and $SmFe_2$, 1.8 % by mass of Si is added at melting, followed by preparing alloy powder by means of gas atomizing process. These respective powders, after the homogenizing heat treatment, are followed by the nitrogen addition treatment at a temperature of 480°C, furthermore followed by the homogenizing treatment. The respective obtained alloy powders are compression molded with resinous binder. It is confirmed that, when comparing with one with no added Si, the magnetic field necessary for saturation is 15 % less in the case of $Tb_{0.5}Dy_{0.5}(Fe_{0.9}Mn_{0.1})_{1.95}$ alloy and 23 % less in the case of $SmFe_2$ alloy.

Next, 2.8 % by mass of Si is added. An improving effect of the magnetic field necessary for saturation is a little enhanced, however the value of magnetostriction itself decreases largely. As a result, from a practical viewpoint, it is confirmed that an addition of approximate 3 % by mass is a limit. The improvement effect of the magnetic field necessary for the saturation is similarly confirmed at the addition of C, P and B.

Embodiment 13

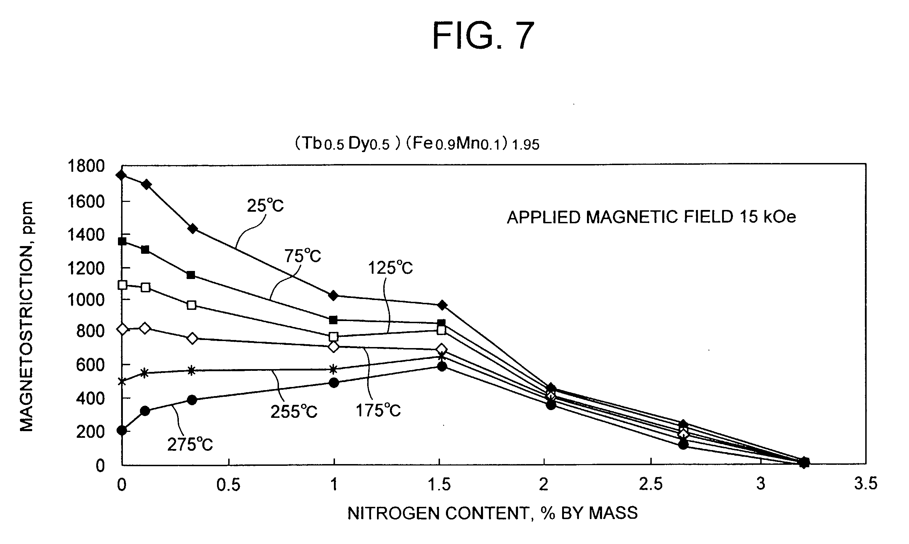

The relationship between the nitrogen content (total nitrogen content) of the alloy of a composition of $Tb_{0.5}Dy_{0.5}(Fe_{0.9}Mn_{0.1})_{1.95}$ prepared due to the unidirectional solidification method and change of magnetostriction is investigated under various temperatures to which the alloy is exposed. The results are shown in Fig. 7. As obvious from Fig. 7, when the nitrogen content exceeds 2.5 % by mass or the temperature is too low, the magnetostriction becomes low to be difficult to put in practical use.

Embodiment 14

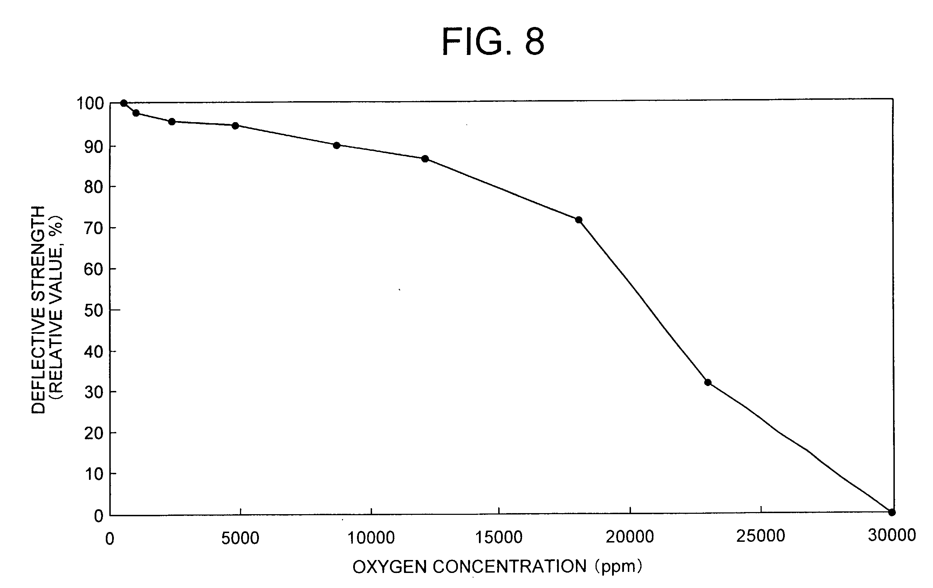

The relationship between oxygen concentration and deflective strength of nitrogen containing magnetostrictive alloy of which composition of mother alloy is $Tb_{0.5}Dy_{0.5}(Fe_{0.9}Mn_{0.1})_{1.95}$ is investigated. Results are shown in Fig. 8. An influence of oxygen is shown in terms of relative strength normalized to the deflective strength of the sample of which oxygen concentration is the lowest. With increasing oxygen concentration, the deflective strength goes down. With a boundary at an oxygen concentration of 20,000 ppm, the strength shows a large drop. When the oxygen concentration is further increased, the alloy cannot maintain its shape to result in self-collapse. The oxygen concentration where mechanical reliability of the magnetostrictive alloy can be guaranteed is 20,000 ppm or less, preferably being 15,000 ppm or less, more preferably being 10,000 ppm or less.

Embodiment 15

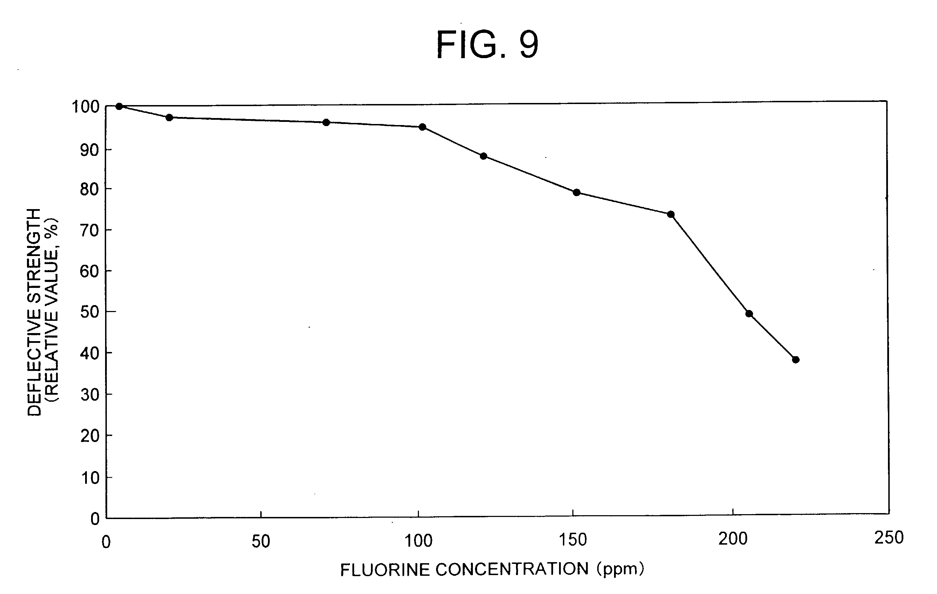

The relationship between fluorine concentration and deflective strength of nitrogen containing magnetostrictive alloy of which composition of mother alloy is $Tb_{0.5}Dy_{0.5}(Fe_{0.9}Mn_{0.1})_{1.95}$ is investigated. Results are shown in Fig. 9. An influence of fluorine is shown in terms of relative strength normalized to the deflective strength of the sample of which fluorine concentration is the lowest. Similarly with oxygen, fluorine is an impurity that damages mechanical reliability, with increasing oxygen concentration, the deflective strength goes down. With a fluorine concentration of approximate 200 ppm as a boundary, the strength shows a large drop. The fluorine concentration where mechanical reliability of the magnetostrictive material can be guaranteed is 200 ppm or less, preferably being 150 ppm or less, more preferably being 100 ppm or less.

Embodiment 16

With an alloy target of a composition $TbFe_2$, by means of high frequency magnetron sputtering process, on a glass substrate and a strain gauge made of polyamide, alloy thin films are sputtered, respectively. Sputtering are implemented under the conditions of input power from 100 to 500 W, Ar pressure from 0.1 to 6.5 Pa and thickness from 0.1 to 5 $\mu$m. For one to which nitrogen is added during sputtering, a pressure of $N_2$ is optimized in the range of $1 \times 10^{-3}$ to 1 Pa. For an alloy film (glass substrate) to which nitrogen is not added during the sputtering, nitrogen is added in a nitrogen atmosphere at a temperature of 500°C.

A nitrogen added magnetostrictive alloy film on the glass substrate shows Curie temperature of 500°C or more at thermomagnetometry due to VSM, an increase of magnetization accompanying segregation of Fe phase being also observed. Furthermore, of the magnetostrictive alloy film on the strain gauge to which nitrogen is added during the sputtering, magnetostriction is measured with an electromagnet. The magnetostriction is found to be approximately 1.5 times that of the alloy film thereto nitrogen is not added.

Furthermore, on the nitrogen added magnetostrictive alloy film on the glass substrate, a planar coil for driving and for detection is disposed to prepare a surface acoustic wave element. With the surface acoustic wave element, delay characteristics of waves due to magneto-elastic effect is measured in an electromagnet. As a result, under a bias magnetic field of at most 50 Oe, variation of sound velocity of approximate 20 % is obtained.

Embodiment 17

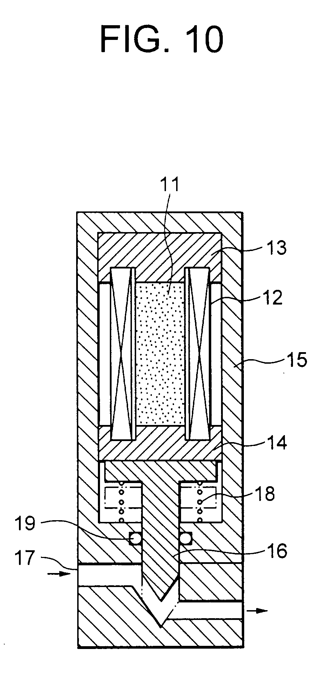

Now, as an example of a magnetostrictive actuator therein the present giant magnetostrictive material is applied, a hydraulic valve is explained with reference to Fig. 10. The hydraulic valve shown in Fig. 10 comprises an alloy rod 11 of a composition $Tb_{0.5}Dy_{0.5}(Fe_{0.9}Mn_{0.1})_{1.95}$ thereto nitrogen is added by 0.7 % by mass for instance. In the giant magnetostrictive alloy rod 11, the average value of interstitially dissolved nitrogen content is 0.68 % by mass, the ratio of the nitrogen content present as nitride to the total nitrogen content is 0.029.

The giant magnetostrictive alloy rod 11 is disposed for the direction of crystallographic orientation to be a longer direction, at the periphery thereof an exciting coil 12 being disposed as magnetic field applying means. One end of the giant magnetostrictive alloy rod 11 is fixed by a fixed yoke 13 and a movable yoke 14 being solidly fixed to the other end thereof. These constituent elements 11, 12, 13 and 14 are disposed inside of a cylindrical yoke 15 to form a closed magnetic circuit.

To the movable yoke 14, a valve 16 movable in a direction of magnetostriction of the giant magnetostrictive alloy rod 11 is attached. The valve 16 is disposed to open an oil path 17. Between the valve 16 and the cylindrical yoke 15, a spring 18 is disposed. The spring 18 applies a preload necessary for obtaining a larger displacement at the application of a magnetic field, and returns the valve 16 from a closed state to an open state. Reference numeral 19 denotes an O-ring sealer.

In the above hydraulic valve, a magnetic field is applied to the giant magnetostrictive alloy rod 11 to generate positive magnetostriction, with the positive magnetostriction (elongation) as a driving force the valve 16 being driven. The valve 16 is configured to close the oil path 17 at the application of the driving force based on the magnetostriction. The hydraulic valve using such giant magnetostrictive alloy rod 11 can not only simply open but also, based on a magnitude of the magnetic field applied on the giant magnetostrictive alloy rod 11, control a ratio of the open state.

In the present embodiment, the giant magnetostrictive alloy rod 11, being constituted of magnetostrictive alloy of a composition $Tb_{0.5}Dy_{0.5}(Fe_{0.9}Mn_{0.1})_{1.95}$ thereto nitrogen is added by 0.7 % by mass, can be normally operated even at an oil temperature of 180°C. On the contrary, when a rod constituted of a magnetostrictive alloy therein nitrogen is not added is employed, the valve can operate normally up to an oil temperature of 100°C, but fails to operate when exceeding 100°C.

Embodiment 18

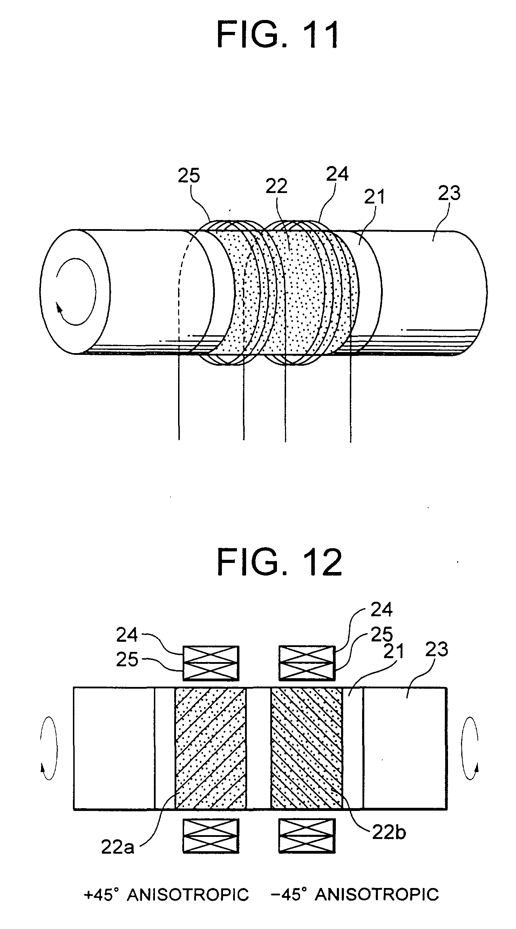

As an example of a magnetostrictive sensor employing the present giant magnetostrictive material, a torque sensor will be explained with reference to Fig. 11. The torque sensor shown in Fig. 11 comprises a giant magnetostrictive alloy film 22 formed along an entire periphery of a pipe 21 (non-magnetic pipe) made of for instance non-magnetic steel.

The giant magnetostrictive alloy film 22 is formed in the following ways. First, on the entire periphery surface of the non-magnetic pipe 21, a thin film of an alloy of a composition $SmFe_2$ is deposited by means of the sputtering method, to the alloy thin film heat treatment for nitrogen addition and homogenization being implemented at 450°C. For the giant magnetostrictive alloy film 22, the total nitrogen content is 1.8 % by mass, the average content of the interstitially dissolved nitrogen being 1.75 % by mass, the ratio of the content of nitrogen present as nitride to the total nitrogen content being 0.028.

A torque detection tube (sensor portion) having the giant magnetostrictive alloy film 22 is inserted and fixed between propeller shafts 23 obtained by cutting fore and aft a propeller shaft 23 of for instance a four-wheeled vehicle. At the periphery of the giant magnetostrictive alloy film 22, an exciting coil 24 and a detector coil 25 are disposed in close proximity in noncontact. On a surface of the giant magnetostrictive alloy film 22, resin coating is applied for rustproof.

In the aforementioned torque sensor, when torque is applied on the propeller shaft 23, at the non-magnetic pipe 21 connected thereto, torsion is generated, strain being generated in the giant magnetostrictive alloy film 22. At that time, by keeping applying an alternating voltage to the exciting coil 24, change of strain due to torsional stress generated in the giant magnetostrictive alloy film 22 can be detected by the detector coil 25 as change of magnetic characteristics. This is useful as a sensor detecting magnitude of torque in noncontact. In the present embodiment, it is confirmed that the torque generated due to the change of strain can be detected with excellent linearity. In addition, temperature dependence of output is confirmed to be small.

In Fig. 12, giant magnetostrictive alloy films 22a and 22b thereto magnetocrystalline anisotropy is given are used. In these giant magnetostrictive alloy films 22a and 22b, in the respective principal directions of stress (plus and minus directions) caused due to the torque, the magnetocrystalline anisotropy is given. According to such torque sensor, torque can be detected with more precision.

Embodiment 19

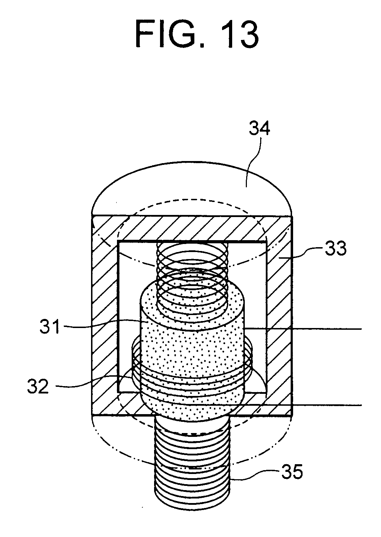

As an example of a magnetostrictive sensor using the present giant magnetostrictive material, a knocking sensor will be explained with reference to Fig. 13. The knocking sensor shown in Fig. 13 comprises a cylindrical giant magnetostrictive alloy rod 31 of for instance a diameter of 5 mm and a length of 5 mm. The giant magnetostrictive alloy rod 31 is configured of $SmFe_2$ alloy therein nitrogen is added by 1.2 % by mass for instance. The average value of interstitially dissolved nitrogen content is 1.18 % by mass, the ratio of the content of nitrogen present as nitride to the total nitrogen content being 0.017.

In the surroundings of the giant magnetostrictive alloy rod 31, a detector coil 32 is disposed. Furthermore, the giant magnetostrictive alloy rod 31, through a pressure bar spring 33, is disposed in a non-magnetic case (for instance, non-magnetic steel case) 34. The non-magnetic case 34 has a fixing screw 35, being installed in an engine block by means of the fixing screw 35.

To the aforementioned knocking sensor, when vibration due to knocking in a cylinder of various kinds of internal combustion engines is transmitted, in the giant magnetostrictive alloy rod 31, strain is generated. With the strain of the giant magnetostrictive alloy rod 31, a current flows in the detector coil to enable to detect the knocking. In an actual engine, fuel injection and ignition being turned on at the limit of knocking and complete combustion, thereby fuel consumption is reduced.

In the knocking sensor of the present embodiment, the giant magnetostrictive alloy rod 31 is composed of $SmFe_2$ alloy therein 1.2 % by mass of nitrogen is added. Accordingly, even at around 200°C, output enough detectable is obtained. On the other hand, when a rod composed of magnetostrictive alloy therein no nitrogen is added is used, the output shows a sharp drop around 100°C.

Embodiment 20

From alloy having a composition of $Tb_{0.5}Dy_{0.5}(Fe_{0.9}Mn_{0.1})_{1.95}$, by means of single roll melt quench process called strip casting process, flakes of a thickness in the range of from 100 to 300 μm and a width of 30 mm are prepared. During the melt quenching, a roll speed is 10 m/sec.

In the obtained flakes, on a roll contact surface and on a free solidification surface side, a slight chilled equiaxed grain is formed, however a main body consists of columnar structure extending in an a thickness direction. Crystallographic direction is investigated by the XRD and found to orient in approximate {1,1,0}. Furthermore, from cross-section observation of the flake, a volume ratio (calculated from area ratio) of the columnar structure grains and a direction of grain growth of the columnar structure are measured. As a result, it is found that a ratio of the columnar structure of which angle between the growth direction thereof and a thickness direction is within 15 degrees is 85 % by volume.

The above flakes are milled to a magnitude of 10 mm or less, while applying vibration thereto, being stacked in a mold of a hot press so that a thickness direction of the flake is a longer direction of a molded body. Then, after evacuation, in an Ar atmosphere, the stacked body is hot pressed at 1000°C to prepare a cylindrical sample of an external diameter of 20 mm and a length of 30 mm.

After the application of homogenizing heat treatment at 800°C to the obtained cylindrical sample, a measuring test piece of a dimension of 10×5×3 mm is cut out to measure magnetostriction. As a result, the magnetostriction under a magnetic field of 239 kA/m is such excellent value as 1100 to 1200 ppm. When the flake of which ratio of the columnar structure where an angle between a growth direction thereof and a thickness direction thereof is within 15 degrees is 63 % by volume is employed, the magnetostriction decreases to one half that of the above.

In addition, alloy flakes having a composition of $Tb_{0.4}Dy_{0.6}(Fe_{0.9}Mn_{0.1})_{1.93}$ are prepared by the method same with the aforementioned process. Texture mainly consisting of the columnar structure is obtained. The columnar structure is approximately oriented in {1,1,1} with respect to a thickness direction. With such flakes, similarly a cylindrical sample is prepared, furthermore a measuring test piece being cut out to measure magnetostriction. The magnetostriction is 350 to 450 ppm.

Comparative Example 3

A cylindrical test piece of an external diameter of 60 mm and a length of 60 mm and consisting of alloy of a composition same with Embodiment 20 is prepared by unidirectional solidification process. After the homogenizing heat treatment at 900°C, an edge portion that is an anomalous texture is cut out by 10 mm each. A crystallographic direction of a cut out surface is investigated by XRD and found to be approximately oriented in {1,1,0}. From the test piece, a measuring test piece of a dimension of 10X5X3 mm is cut out and is measured of the magnetostriction. It is found to be 1550 to 1650 ppm under a magnetic field of 239 kA/m. However, necessity of cutting out the anomalous texture causes an increase of material cost.

Comparative Example 4

By the same method with Embodiment 1, from alloy having a composition of $Tb_{0.5}Dy_{0.5}(Fe_{0.9}Mn_{0.1})_{1.95}$, flakes of a thickness from 1000 to 1200 $\mu$m are prepared at one half quenching roll speed. In the obtained flakes, on a roll contact surface a little chilled isotropic structure is formed, and on a free solidification surface side an isotropic structure of a thickness from 100 to 300 $\mu$m is found. In between, there are formed columnar structure grains extending in a thickness direction. From the free solidification surface side, crystallographic direction is checked by XRD and no particular predominance is found in crystallographic orientation.

Such flake material is milled to a dimension of 10 mm or less, thereafter being stacked in a mold of a hot press. After evacuation, in an Ar atmosphere the stacked body is hot pressed at 1000°C to obtain a cylindrical test piece of an external diameter of 20 mm and a length of 30 mm. After the homogenizing heat treatment at 800°C, a measuring test piece of a dimension of $10 \times 5 \times 3$ mm is cut out to measure the magnetostriction. As a result, only low magnetostriction from 340 to 660 ppm is obtained under a magnetic field of 239 kA/m.

Embodiment 21

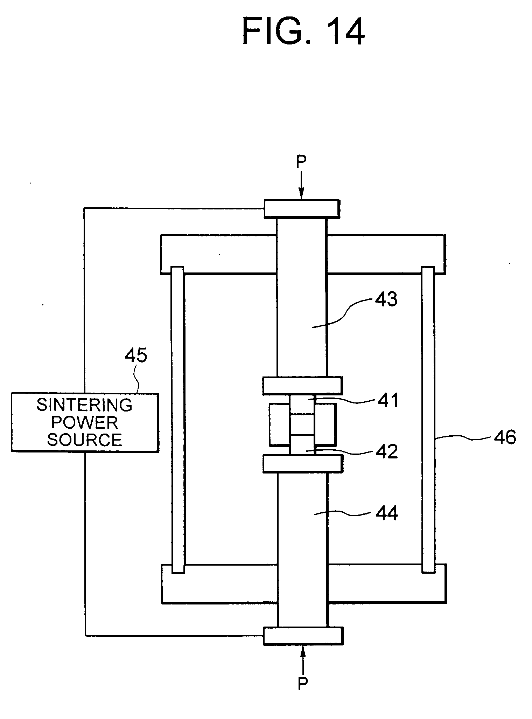

The flake material prepared by the same method with Embodiment 20 is milled to a dimension of 10 mm or less. While giving vibration thereto, in a device for spark plasma sintering as shown in Fig. 14, the milled flake material is stacked for a thickness direction of the flake to direct a longer direction of the molded body. In Fig. 14, reference numerals 41, 42, 43, 44, 45 and 46 denote upper punch, lower punch, upper punch electrode, lower punch electrode, power source for sintering and water-cooled vacuum chamber, respectively.

After evacuating the spark plasma sintering device, in an Ar atmosphere under a pressure from 30 to 50 MPa, spark plasma sintering is implemented to obtain a cylindrical sample of a dimension of an external diameter of 20 mm and a length of 20 mm. After the homogenizing heat treatment at 1000°C, a test piece of a dimension of $10 \times 5 \times 3$ mm is cut out to measure the magnetostriction. As a result, the magnetostriction from 1120 to 1260 ppm is obtained under a magnetic field of 239 kA/m.

Embodiment 22

The alloy of the same composition with Embodiment 20 is melted in a quartz nozzle and sprayed from a round opening of a diameter of 0.7 mm on a quench roll to prepare flakes. A dimension of the obtained flake is a thickness from 230 to 260 $\mu$m and a width from 0.7 to 0.8 mm. The state of orientation of the flake is checked by XRD and found to be oriented in approximate {1,1,0}. The flake is milled to a dimension of 10 mm or less, thereafter similarly with Embodiment 1, followed by molding, heat treatment and cutting out of a measuring test piece. The obtained test piece undergoes magnetostriction measurement to show values from 870 to 1010 ppm under a magnetic field of 239 kA/m.

Though excellent in orientation in a state of flake, due to a narrow width relative to a thickness, the shape effect does not work well, during the molding, disordering in the stacking of the flakes being caused. As a result, the magnetostriction is considered to be a little low. When observing texture of a section with an optical microscope, there is found a trace of flake tilting with respect to a desired direction. A relatively longer flake is likely to tilt more relative to a desired direction. Longer flakes are considered to entangle each other to disturb fluidity. As a result, the stacking in a thickness direction due to the shape effect is considered to be difficult.

From these results, it is found that a minor axis of a flake is preferable to be 3 times or more a thickness of the flake. Furthermore, too elongated shape is not preferable, a major axis being preferable to be 20 times or less the minor axis.

Embodiment 23

By adjusting a peripheral speed of roll, material and round opening of the quartz nozzle, alloys of the same composition with Embodiment 20 are melt-quenched to prepare various flakes having a thickness provided in the present invention. The free solidification surface sides of these test pieces are measured by XRD. It is confirmed that a peak intensity ratio of a peak showing {1,1,0} direction to a reference peak is 1.45 to 4.2 times that for random orientation.

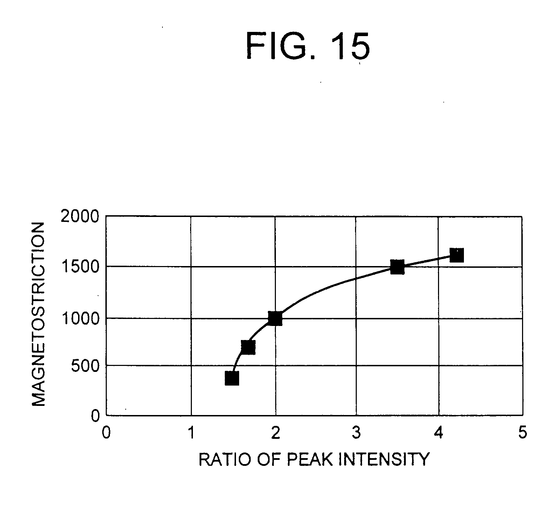

Such flake materials are formed in cylinder by the identical method with Embodiment 21, the respective test pieces cut out from these samples being measured of magnetostriction. The results are shown in Fig. 15. The magnetostriction increases with increasing peak intensity ratio, one having the ratio of 4.2 showing the magnetostriction approximately identical with that of the unidirectionally solidified material. From a practical viewpoint, the peak intensity ratio at the orientation is preferable to be 1.5 times or more that in random orientation.

Embodiment 24

The flakes prepared by the same method with Embodiment 20, after milling down to 5 mm or less, are immersed in a thermosetting epoxy resin solution diluted by acetone, followed by volatilization in a vacuum vessel to remove acetone. This is molded by a press under a pressure of 980 kPa, followed by curing the resin at 150°C to obtain a cylindrical sample of an external diameter of 20 mm and a length of 20 mm. The magnetostriction is 900 to 970 ppm under a magnetic field of 239 kA/m.

Furthermore, the obtained sample is cut to investigate the orientation of the flake. As a result, with exception of portions from about 1 to 3 mm on a periphery surface and a base surface of the sample, a thickness direction of the flake is confirmed to orient in a direction of compression. Furthermore, it is confirmed that due to the compression, the flake is broken to down a dimension of one of several or less that of the initial flake.

Embodiment 25

A cylindrical sample is prepared by the same method with Embodiment 20. The cylindrical samples are heat-treated in an Ar atmosphere at 950°C for from 0 to 96 h. As a result, it is confirmed that with increasing the time for heat treatment, the magnetostriction increases. When the texture observation is carried out, grain growth is confirmed. It is considered that due to the heat treatment, grains grow, and anomalous texture and internal strain present in the flake disappear to result in an improvement of the orientation.

Embodiment 26

Ones that are obtained by milling the same flake with Embodiment 20 to 10 mm or less and to fine powder of 35 $\mu$m or less are mixed with a ratio of 8:2 and integrated by means of the spark plasma sintering same with Embodiment 21. In the spark plasma sintering, while deforming, the molding proceeds. In the present Embodiment, a time necessary to complete the deformation is one half that when the fine powder is not added.

Subsequently, under the same conditions with Embodiment 21 the homogenizing heat treatment is implemented. The magnetostriction is from 950 to 1030 ppm. When applying again the heat treatment, the magnetostriction is enhanced to from 1200 to 1280 ppm. It is considered that at the first heat treatment fine powder portion remains disturbed in the orientation, but at the second heat treatment due to grain growth disordering disappears. Considering productivity, the time necessary for the spark plasma sintering is better to be shorter, but thereafter it takes a longer time for the heat treatment. In addition, too much fine powder may cause an increase of oxygen concentration.

From these results, an amount of fine powder as a sintered additive is preferable to be 30 % by mass or less. To enhance an effect as the sintered additive, to the mother composition, B, Si, C or the like that are melting point suppressing elements may be added to an extent that does not remarkably disturb the magnetostriction.

Embodiment 27

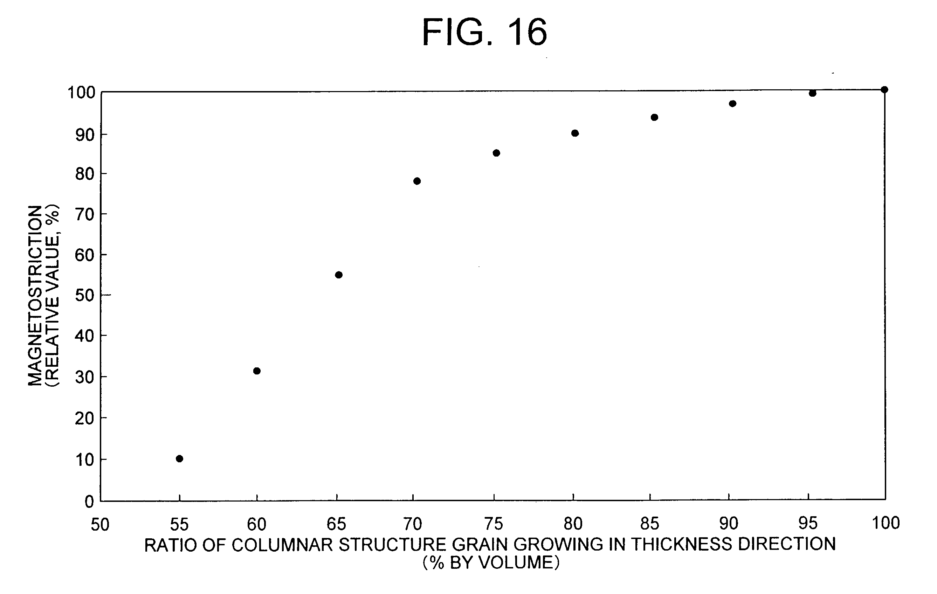

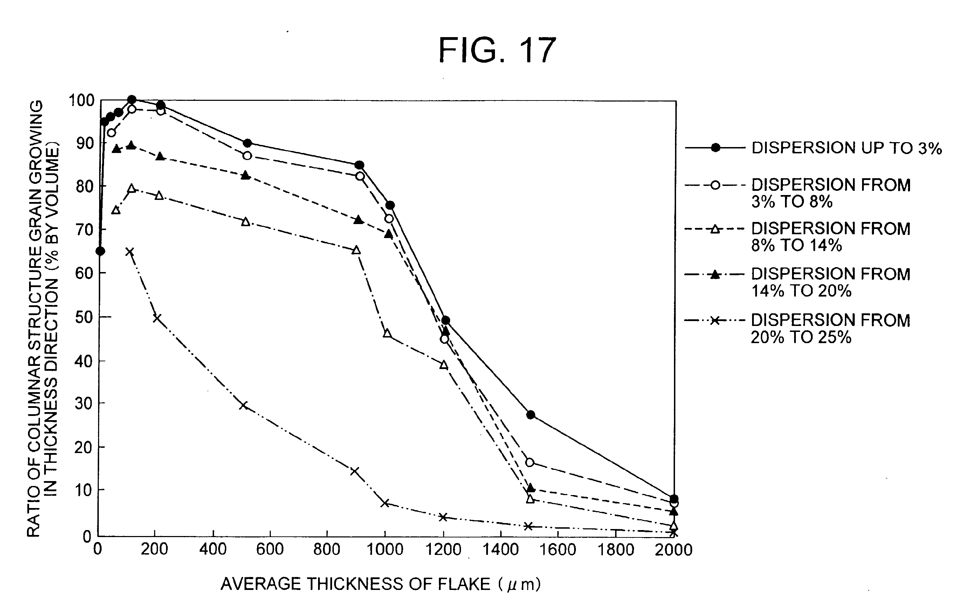

In Fig. 16, the relationship between volume ratio of columnar structure (columnar structure of which an angle between a growth direction of the columnar structure and a thickness direction measured from cross-section observation is within 15 degrees) growing in a thickness direction of the flake material and magnetostriction (relative value normalized to the value when only columnar structure is contained) is shown. Furthermore, in Fig. 17, the relationship between average thickness of the flake material and volume ratio of the columnar structure (the same with the above) is shown with dispersion of the thickness as parameter. In the measurement of the thickness of the flake material and the volume ratio of the columnar structure, cross-section observation is carried out of 5 fields or more for each sample, an average value of these being taken as a measurement. As to the volume ratio of the columnar structure, with an image analyzer, areas of the columnar structure and the portion other than that are measured, a ratio of these areas being taken as the volume ratio.

As obvious from Fig. 16, in the flake material containing the columnar structure by 70 % or more by volume, that is, the flake material of which volume ratio of cubic grain to columnar structure is in the range from 0:100 to 30: 70, practically sufficient magnetostriction can be obtained. From Fig. 17, when the average thickness of the flake material is less than 10 μm, the columnar structure growing in a thickness direction can be obtained with difficulty. On the other hand, also when the average thickness exceeds 1000 μm, the columnar structure growing in a thickness direction can be obtained with difficulty. Furthermore, with increasing dispersion of the thickness, the columnar structure growing in a thickness direction becomes more difficult to obtain. Accordingly, the dispersion of the thickness is preferable to be 20 % or less.

Embodiment 28

Longer ribbons of an average thickness of 100 μ m, a width of 2mm and a length of from 5 to 100 mm are milled. Thereafter, the milled material is effected to go through a sieve having a mesh of 500 μm to prepare the flake material for molding. Shape of much of the flake material is in a broken state in a thickness direction while maintaining a thickness of 100 μm. In 70 % or more of the flake material, the minor axis is in the range of from 300 to 900 μm. In the remaining flake material, the minor axis is less than 300 μm. Such flake material is molded by the same method with Embodiment 20.

Next, the same longer ribbon, after milling, is passed through a sieve with a mesh of 300 μm to obtain flake material for molding. Shape of much of the flake material is in a broken state in a thickness direction while maintaining a thickness of 100 μm. In 70 % or more of the flake material, the minor axis is in the range of from 100 to 300 μm. In the remaining flake material, the minor axis is less than 100 μm. Such flake material is molded by the same method with Embodiment 20.

The magnetostriction of both samples are compared. It is found that the magnetostriction of the latter one is only 13 % of that of the former, the crystallographic direction of the molded body being hardly oriented. From these results, when the minor axis of the flake material is 3 times or less the thickness, it is difficult to stack arranged in a thickness direction.

Next, the same longer ribbon is cut in 5 to 10 mm, 10 to 20 mm, 20 to 40 mm, 40 to 60 mm and 60 to 100 mm to prepare flake materials. The respective flake materials and flake material cut in from 2 to 5 mm are mixed at a ratio of 8:2. Each of these mixtures is put in a vessel of a diameter of 200 mm, followed by vibrating to check whether stacks in a thickness direction or not. As a result, ones in which the flake materials of 5 to 10 mm, 10 to 20 mm and 20 to 40 mm are mixed respectively stack in a thickness direction in a short time. Whereas, in ones where the flake materials of 40 to 60 mm and 60 to 100 mm are mixed respectively, longer flakes do not stack in a short time. From these, the major axis of the flake material is preferable to be 20 times or less the minor axis.

Embodiment 29

With giant magnetostrictive material obtained by stacking and heat treating melt quench material, a hydraulic valve having a structure shown in Fig. 10 is manufactured, being tested of performance. Displacement and durability are almost the same with that of one manufactured of unidirectionally solidified material. It is confirmed that the dispersion of the performance between products is one half or less that of ones manufactured with the unidirectionally solidified material.

As obvious from the aforementioned embodiments, in the first giant magnetostrictive material of the present invention, nitrogen is effectively introduced interstitially in rare earth-transition metal alloy to largely suppress nitride from forming. Accordingly, while maintaining excellent magnetostriction and mechanical characteristics, the Curie temperature can be enhanced with good reproducibility. Thereby, giant magnetostrictive material combining high Curie temperature and excellent magnetostriction can be provided. According to a magnetostrictive actuator and magnetostrictive sensor having such giant magnetostrictive material, under a high temperature environment performance and reliability can be largely enhanced.

According to a second giant magnetostrictive material of the present invention, by the use of flake-like melt quench alloy, the giant magnetostrictive material that is excellent in magnetostriction and mechanical performance, and can improve productivity and save the waste of material can be provided. Thereby, high performance and less expensive giant magnetostrictive material can be provided with reproducibility. By the use of such giant magnetostrictive material, a magnetostrictive actuator and magnetostrictive sensor can be improved in performance and reliability, and manufacturing cost being reduced.

The appended claims are not limited to the embodiments described herein, but rather are intended to cover all variations and adaptations falling within the true scope and spirit of the present invention.

**Claims**

1. Giant magnetostrictive material, comprising:

   a mother alloy consisting essentially of a rare earth element and a transition metal element; and
   nitrogen contained in the mother alloy;
   wherein the nitrogen is interstitially introduced in the mother alloy, a content of a nitrogen compound (nitride) in the mother alloy, as a ratio of a content of nitrogen contained in the nitrogen compound to a total nitrogen content in the mother alloy, being 0.05 or less by mass ratio.

2. The giant magnetostrictive material as set forth in claim 1:
   wherein the nitrogen is contained in the mother alloy in the range from 0.01 to 2.5 % by mass.

3. The giant magnetostrictive material as set forth in claim 1:
   wherein dispersion of the content of nitrogen introduced interstitially in the mother alloy is, with respect to an average value, within ± 30 %.

4. The giant magnetostrictive material as set forth in claim 1:
   wherein a lattice constant of a grain of the mother alloy therein the nitrogen is introduced is increased by 0.1 % or more in comparison with that before introduction of the nitrogen.

5. The giant magnetostrictive material as set forth in claim 1:
   wherein the giant magnetostrictive material comprises unidirectionally solidified material, single crystal material, melt quench material or sintered material.

6. The giant magnetostrictive material as set forth in claim 1:
   wherein the giant magnetostrictive material comprises cubic cast material.

7. The giant magnetostrictive material as set forth in claim 1:
   wherein the giant magnetostrictive material comprises an alloy thin film due to a film deposition process.

8. The giant magnetostrictive material as set forth in claim 5:
   wherein, in 80 % or more by volume of grains in the alloy, a crystallographic direction in a direction of an applied magnetic field is oriented within ± 45 degrees from a crystallographic direction {1,1,1} or {1,1,0}.

9. The giant magnetostrictive material as set forth in claim 1:
   wherein the mother alloy comprises a composition essentially expressed by

$$\text{a general formula: } R(T_X M_{1-X})_Z$$

   (in the formula, R denotes at least one kind of element selected from rare earth elements including Y, T denotes at least one kind of element selected from Fe, Co and Ni, M denotes at least one kind of element selected from transition elements other than the T elements, and x and Z are numbers satisfying $0.5 \leqq X \leqq 1$, $1.4 \leqq Z \leqq 2.5$).

10. The giant magnetostrictive material as set forth in claim 1:
    wherein an oxygen content of the mother alloy is 20000 ppm or less.

11. The giant magnetostrictive material as set forth in claim 1:
    wherein a total content of fluorine and chlorine in the mother ally is 200 ppm or less.

12. The giant magnetostrictive material as set forth in claim 1:
    wherein the mother alloy comprises at least one kind selected from hydrogen, boron, carbon, phosphorus and silicon in the range from 0.0001 to 3 % by mass.

**13.** The giant magnetostrictive material as set forth in claim 1:

wherein the giant magnetostrictive material has magnetostriction of 200 ppm or more.

**14.** Giant magnetostrictive material, comprising:

melt quench flakes that comprise an alloy consisting essentially of a rare earth element and a transition metal element, and contain columnar structure extending in a thickness direction as a main crystal structure;
wherein the melt quench flakes are integrated stacked in a thickness direction.

**15.** The giant magnetostrictive material as set forth in claim 14:

wherein the melt quench flakes contain the columnar structure grains by 70 % or more by volume ratio.

**16.** The giant magnetostrictive material as set forth in claim 14:

wherein, in the columnar structure of the melt quench flakes, a crystallographic direction in the thickness direction is approximate orientation in {1,1,1} or {1,1,0}.

**17.** The giant magnetostrictive material as set forth in claim 16:

wherein, in an X-ray diffraction pattern of the melt quench flakes, a ratio of a peak intensity of a plane of crystallographic orientation of the columnar structure to that of a reference peak is 1.5 times or more that in random orientation.

**18.** The giant magnetostrictive material as set forth in claim 14:

wherein the melt quench flakes have an average thickness in the range from 10 to 1000 $\mu$ m.

**19.** The giant magnetostrictive material as set forth in claim 18:

wherein dispersion of the thickness of the melt quench flakes is within $\pm$ 20 % of the average thickness.

**20.** The giant magnetostrictive material as set forth in claim 14:

wherein the alloy comprises a composition essentially expressed by

$$\text{a general formula: } R(T_X M_{1-X})_Z$$

(in the formula, R denotes at least one kind of element selected from rare earth elements including Y, T denotes at least one kind of element selected from Fe, Co and Ni, M denotes at least one kind of element selected from transition elements other than the T elements, and x and Z are numbers satisfying $0.5 \leqq X \leqq 1$, $1.4 \leqq Z \leqq 2.5$).

**21.** The giant magnetostrictive material as set forth in claim 14:

wherein the alloy comprises nitrogen in the range from 0.01 to 2.5 % by mass, the nitrogen being interstitially introduced in the alloy.

**22.** The giant magnetostrictive material as set forth in claim 21:

wherein a content of a nitrogen compound in the alloy, as a ratio of a content of nitrogen contained in the nitrogen compound to a total nitrogen in the alloy, is 0.05 or less by mass ratio.

**23.** A method for manufacturing giant magnetostrictive material, comprising the steps of:

heat treating a mother alloy consisting essentially of a rare earth element and a transition metal element in an atmosphere of a vacuum or an inert gas; and
introducing nitrogen interstitially between crystal lattice of the mother alloy in a temperature range of 600°C or less.

**24.** The method for manufacturing giant magnetostrictive material as set forth in claim 23:

wherein the nitrogen introducing step is controlled so that the nitrogen is contained in the mother alloy in the range from 0.01 to 2.5 % by mass, and a content of nitrogen compound in the mother alloy, by a mass ratio of a content of nitrogen contained in the nitrogen compound to a total nitrogen content in the mother alloy, is 0.05 or less.

**25.** The method for manufacturing giant magnetostrictive material as set forth in claim 23:

wherein the nitrogen introducing step comprises a step of heat treating the mother alloy in an atmosphere containing nitrogen at a temperature in the range from 200 to 600°C.

26. The method for manufacturing giant magnetostrictive material as set forth in claim 23:
wherein the nitrogen introducing step comprises a step of mechanical alloying the mother alloy in an atmosphere containing nitrogen.

27. A method for manufacturing giant magnetostrictive material, comprising the steps of:

quenching alloy melt consisting essentially of a rare earth element and a transition metal element to prepare melt quench flakes containing columnar structure extending in a thickness direction as a main crystal structure; and
stacking the melt quench flakes in a direction of thickness to integrate a stacked body of the melt quench flakes.

28. The method for manufacturing giant magnetostrictive material as set forth in claim 27:
wherein the integrating step comprises a step of stacking the melt quench flakes for a crystallographic direction of a direction of thickness of the columnar structure to orient.

29. The method for manufacturing giant magnetostrictive material as set forth in claim 27:
wherein the integrating step comprises a step of hot pressing or spark plasma sintering the stacked body of the melt quench flakes.

30. The method for manufacturing giant magnetostrictive material as set forth in claim 29:
wherein to the melt quench flakes, as a sintered additive, fine powder of the same constituent with the melt quench flakes or fine powder that fuses with the melt quench flakes to form a target constituent is added in the range of 30 % or less by mass to the melt quench flakes.

31. The method for manufacturing giant magnetostrictive material as set forth in claim 27:
wherein the integrating step comprises a step of integrating the stacked body of the melt quench flakes by the use of a resinous binder.

32. The method for manufacturing giant magnetostrictive material as set forth in claim 27:
wherein 70 % or more by mass of the melt quench flakes have a dimension of (minor axis of flake)>3× (average thickness of flake) and (major axis of flake)/(minor axis of flake) = 1 to 20.

33. A magnetostrictive actuator, comprising:
giant magnetostrictive material set forth in claim 1.

34. A magnetostrictive actuator, comprising:
giant magnetostrictive material set forth in claim 14.

35. A magnetostrictive sensor, comprising:
giant magnetostrictive material set forth in claim 1.

36. A magnetostrictive sensor, comprising:
giant magnetostrictive material set forth in claim 14.

# FIG. 1

# FIG. 2A

# FIG. 2B

# FIG. 3

DIRECTION OF APPLIED MAGNETIC FIELD

1

1

α

# FIG. 4

1

THICKNESS

MAJOR AXIS

MINOR AXIS

# FIG. 5A

# FIG. 5B

# FIG. 5C

# FIG. 6

## FIG. 7

$(Tb_{0.5} Dy_{0.5}) (Fe_{0.9}Mn_{0.1})_{1.95}$

APPLIED MAGNETIC FIELD 15 kOe

25°C
75°C
125°C
255°C      175°C
275°C

MAGNETOSTRICTION, ppm

NITROGEN CONTENT, % BY MASS

EP 1 124 268 A2

# FIG. 8

# FIG. 9

DEFLECTIVE STRENGTH (RELATIVE VALUE, %) vs FLUORINE CONCENTRATION (ppm)

# FIG. 10

# FIG. 11

# FIG. 12

+45° ANISOTROPIC   −45° ANISOTROPIC

# FIG. 13

# FIG. 14

# FIG. 15

FIG. 16

# FIG. 17

EP 1 124 268 A2

# FIG. 18

# FIG. 19

COOLED SURFACE